(19)

Europäisches
Patentamt
European
Patent Office
Office européen
des brevets

(11)　**EP 1 840 944 A1**

(12)　**EUROPEAN PATENT APPLICATION**
published in accordance with Art. 158(3) EPC

(43) Date of publication:
　　03.10.2007 Bulletin 2007/40

(51) Int Cl.:
　　*H01L 21/027*　(2006.01)　　*G03F 7/20*　(2006.01)

(21) Application number: **06711689.7**

(86) International application number:
　　**PCT/JP2006/300404**

(22) Date of filing: **13.01.2006**

(87) International publication number:
　　**WO 2006/075720 (20.07.2006 Gazette 2006/29)**

(84) Designated Contracting States:
　　**AT BE BG CH CY CZ DE DK EE ES FI FR GB GR
　　HU IE IS IT LI LT LU LV MC NL PL PT RO SE SI
　　SK TR**

(30) Priority: **14.01.2005 JP 2005007125**

(71) Applicant: **NIKON CORPORATION
　　Tokyo 100-8331 (JP)**

(72) Inventor: **SHIRAISHI, Naomasa,
　　NIKON CORPORATION
　　Tokyo 100-8331 (JP)**

(74) Representative: **Hooiveld, Arjen Jan Winfried
　　Arnold & Siedsma
　　Sweelinckplein 1
　　2517 GK Den Haag (NL)**

(54)　**EXPOSURE METHOD AND APPARATUS, AND ELECTRONIC DEVICE MANUFACTURING METHOD**

(57)　An exposure method provided is a high-resolution and inexpensive method suitable for use in formation of a fine pattern for making up an electronic device. A diffraction grating is located in proximity to a wafer or the like for making up an electronic device, and illumination light with a predetermined incidence angle property is applied onto the diffraction grating to effect exposure on the wafer. The exposure is done while changing a positional relation between the semiconductor wafer and the diffraction grating according to need.

**Fig.1**

EP 1 840 944 A1

**Description**

Technical Field

The present invention relates to an exposure method used in a fine pattern forming step in a process of manufacturing electronic devices such as semiconductor integrated circuits, flat panel display devices, thin-film magnetic heads, and micro machines, and an electronic device manufacturing method using the exposure method, and to an exposure apparatus suitable for use in the same method, and an illumination optical apparatus suitable for use in the exposure apparatus.

Background Art

The photolithography technology is generally used in a step of forming a fine pattern in the process of manufacturing the electronic devices such as the semiconductor integrated circuits. This is to form a photoresist (photosensitive thin film) on a surface of a substrate to be processed, e.g., a wafer and to perform an exposure step with exposure light having a light quantity distribution according to a shape of a pattern to be formed, a development step, etching step, etc. to form a desired pattern on the substrate to be processed.

The projection exposure method is mainly used as an exposure method in the above-described exposure step in manufacture of the presently most-advanced electronic devices. This is to form a fourfold or fivefold magnified pattern with respect to a pattern to be formed, on a mask (or reticle), to apply illumination light onto it, and to guide transmitted light thereof through a reduction projection optical system to transfer a reduced image of the pattern onto the wafer.

The degree of fineness of the pattern that can be formed by the projection exposure method is determined by the resolution of the reduction projection optical system and it is approximately equal to a value obtained by dividing the exposure wavelength by the numerical aperture (NA) of the projection optical system. Therefore, in order to form a finer circuit pattern, it is necessary to prepare an exposure light source of a shorter wavelength and a projection optical system of a higher NA.

On the other hand, there is also an exposure method of effecting exposure of the pattern formed on the mask, on the wafer without intervention of the projection optical system (which will be referred to as "proximity exposure method"). The proximity exposure method is to locate the mask in which the pattern to be transferred is formed at the magnification of ×1, opposite to and in proximity to the wafer, and to apply the illumination light onto the mask to transfer the light-dark pattern of the mask onto the wafer while keeping the shape of the pattern.

There is also a "contact exposure method" of applying the illumination light onto the mask in a state in which the mask and wafer of the same magnification are kept in contact with each other, and transferring the light-dark pattern of the mask onto the wafer as it is.

DISCLOSURE OF THE INVENTION

Problems to be Solved by the Invention

In order to achieve a higher resolution, the projection exposure method among the conventional exposure methods requires the light source of a shorter wavelength and the projection optical system of a higher NA.
In the presently most-advanced exposure apparatus, however, the wavelength of the exposure light is already decreased to as short as 193 nm and it is hard to further decrease the wavelength in the future, in terms of available lens materials.

Furthermore, the NA of the presently most-advanced projection optical systems is approximately 0.92 and a further increase in NA is difficult and would largely raise manufacturing cost of the exposure apparatus.
On the other hand, the contact exposure method involves effecting the exposure with the mask being kept in contact with the substrate, and it is thus difficult to avoid damage or contamination of the mask in conjunction with the exposure. Therefore, running cost would rise with wasting of the mask and it is hard to apply it to mass production.

The proximity exposure method effectively prevents the damage of the mask because the wafer and the mask are arranged opposite and in proximity to each other with a gap of 10-20 $\mu$m or more. This gap, however, causes unsharpness of the transferred pattern and it is thus difficult to apply it to transfer of a fine pattern equal to or smaller than the wavelength of the exposure light.

The present invention has been accomplished in view of the above-described problems, and an object of the present invention is to provide an exposure method capable of inexpensively forming a fine pattern, specifically, a fine pattern of not more than about the wavelength of the exposure light.

Another object of the present invention is to provide an electronic device manufacturing method using the above exposure method, and also to provide an exposure apparatus suitable for use in the above exposure method, or an illumination optical apparatus suitable for use in the exposure apparatus.

Means for Solving the Problems

A first exposure method as an aspect of the present invention is an exposure method of effecting exposure of a pattern on a photosensitive substrate with illumination light from a light source, the exposure method comprising: a step of applying the illumination light from the light source onto a first diffraction grating; a step of applying diffracted light generated by the first diffraction grating, onto a second diffraction grating arranged opposite to the first diffraction grating; and a step of applying diffracted light generated by the second diffraction grating, onto the photosensitive substrate arranged opposite to and in proximity to the second diffraction grating; wherein a major portion of the illumination light applied onto an arbitrary point of the first diffraction grating comprises a plurality of illumination light beams having respective traveling directions in at least one specific plane including a longitudinal direction perpendicular to a direction of a period of the second diffraction grating, and including the point, and the traveling directions are not parallel to each other.

The first exposure method of the invention can also be arranged as follows: an intensity distribution of the illumination light applied onto the first diffraction grating is substantially uniform in a predetermined region including a central portion of the first diffraction grating.

The first exposure method of the invention can also be arranged as follows: at least either the first diffraction grating or the second diffraction grating is a diffraction grating having a period of not more than three times an effective wavelength of the illumination light.

The first exposure method can also be arranged as follows: at least either the first diffraction grating or the second diffraction grating is a phase modulation type diffraction grating to modulate a phase of transmitted light.

Alternatively, the first exposure method can also be arranged as follows: at least either the first diffraction grating or the second diffraction grating is an intensity modulation type diffraction grating to modulate an intensity of transmitted light.

In these arrangements, the first exposure method of the invention can also be arranged as follows: a period in a first predetermined direction of the first diffraction grating is substantially twice the period in the first predetermined direction of the second diffraction grating.

Furthermore, the first exposure method of the invention can also be arranged as follows: the specific plane is one plane substantially perpendicular to the substrate.

It can also be arranged as follows: the specific plane is one plane inclined at a predetermined angle of inclination relative to a direction of a normal to the substrate.

It can also be arranged as follows: the specific plane is two planes inclined substantially in symmetry at a predetermined angle of inclination relative to a direction of a normal to the substrate.

Furthermore, the first exposure method of the invention can also be arranged as follows: while a relative positional relation in in-plane directions of the substrate between the second diffraction grating and the substrate is shifted in the direction perpendicular to the direction of the period of the second diffraction grating, or shifted in the direction of the period by a length equal to an integral multiple of the period of the second diffraction grating, the steps are repeatedly carried out plural times.

The first exposure method of the invention can also be arranged as follows: a space between the second diffraction grating and the substrate is filled with a dielectric having a refractive index of not less than 1.2 at a wavelength of the exposure.

The first exposure method of the invention can also be arranged as follows: a space between the first diffraction grating and the second diffraction grating is filled with a dielectric having a refractive index of not less than 1.2 at the exposure wavelength.

A second exposure method according to another aspect of the present invention is an exposure method of effecting exposure of a pattern on a photosensitive substrate with illumination light from a light source, the exposure method comprising: a step of applying the illumination light from the light source onto a diffraction grating; and a step of applying diffracted light generated by the diffraction grating, onto the photosensitive substrate arranged opposite to and in proximity to the diffraction grating; wherein a major portion of the illumination light applied onto an arbitrary point of the diffraction grating comprises a plurality of illumination light beams having respective traveling directions in at least one specific plane including a longitudinal direction perpendicular to a direction of a period of the diffraction grating, and including the point, and the traveling directions are not parallel to each other.

The second exposure method of the invention can also be arranged as follows: an intensity distribution of the illumination light applied onto the diffraction grating is substantially uniform in a predetermined region including a central portion of the diffraction grating.

The second exposure method of the invention can also be arranged as follows: the diffraction grating is a diffraction grating having a period of not more than three times an effective wavelength of the illumination light.

The second exposure method can also be arranged as follows: the diffraction grating is a phase modulation type diffraction grating to modulate a phase of transmitted light.

Furthermore, the second exposure method can also be arranged as follows: the diffraction grating is an intensity modulation type diffraction grating to modulate an intensity of transmitted light.

The second exposure method of the invention can also be arranged as follows: the specific plane is one plane substantially perpendicular to the substrate.

Alternatively, the second exposure method of the invention can also be arranged as follows: the specific plane is one plane inclined at a predetermined angle of inclination relative to a direction of a normal to the substrate.

Moreover, the second exposure method of the invention can also be arranged as follows: the specific plane is two planes inclined substantially in symmetry at a predetermined angle of inclination relative to a direction of a normal to the substrate.

Furthermore, the second exposure method of the invention can also be arranged as follows: while a relative positional relation in in-plane directions of the substrate between the diffraction grating and the substrate is shifted in the direction perpendicular to the direction of the period of the diffraction grating, or shifted in the direction of the period by a length equal to an integral multiple of the period of the diffraction grating, the steps are repeatedly carried out plural times.

The second exposure method of the invention can also be arranged as follows: a space between the diffraction grating and the substrate is filled with a dielectric having a refractive index of not less than 1.2 at a wavelength of the exposure.

A first electronic device manufacturing method according to another aspect of the present invention uses the exposure method of the present invention in at least one of steps of forming a circuit pattern for making up an electronic device.

A second electronic device manufacturing method according to still another aspect of the present invention uses combined exposure of a projection exposure method using a projection exposure apparatus, and the exposure method of the present invention, in at least one of steps of forming a circuit pattern for making up an electronic device.

A first exposure apparatus according to another aspect of the present invention is an exposure apparatus for effecting exposure on a photosensitive substrate, of an interference pattern generated by a first diffraction grating formed in a first optically-transparent flat plate and a second diffraction grating formed in a second optically-transparent flat plate, with illumination light from a light source, the exposure apparatus comprising: a first holding mechanism which holds the first diffraction grating formed in the first optically-transparent flat plate, at a predetermined position; a second holding mechanism which holds the second diffraction grating formed in the second optically-transparent flat plate, in alignment at a position opposite to the first diffraction grating; a substrate holding mechanism which holds the substrate in alignment at a position opposite to and in proximity to the second diffraction grating; and an illumination optical system which applies the illumination light from the light source onto the first diffraction grating, wherein a major portion of the illumination light applied onto an arbitrary point of the first diffraction grating comprises a plurality of illumination light beams having respective traveling directions in at least one specific plane including a Y-direction, which is a specific direction in a plane on which the substrate is placed, and including the point, and the traveling directions are not parallel to each other.

The first exposure apparatus of the invention can also be arranged as follows: the illumination optical system comprises illumination light uniformizing means which substantially uniformizes an intensity distribution of the illumination light in a plane on which the first diffraction grating is placed. The illumination light uniformizing means can be one including at least one fly's eye lens in which lens elements are arrayed along the Y-direction.

Furthermore, the first exposure apparatus of the invention can also be arranged as follows: the illumination light uniformizing means comprises a condensing optical system which substantially limits illumination light incident to an arbitrary lens element in the at least one fly's eye lens, to illumination light distributed in a predetermined range in an X-direction perpendicular to the Y-direction, among illumination light distributed in a predetermined plane on the light source side with respect to the fly's eye lens in the illumination light uniformizing means.

The first exposure apparatus of the invention can also be arranged as follows: the specific plane is one plane substantially perpendicular to the plane on which the substrate is placed.

Alternatively, the first exposure apparatus of the invention can also be arranged as follows: the specific plane is one plane inclined at a predetermined angle of inclination relative to a direction of a normal to the plane on which the substrate is placed.

Moreover, the first exposure apparatus of the invention can also be arranged as follows: the specific plane is two planes inclined substantially in symmetry at a predetermined angle of inclination relative to a direction of a normal to the plane on which the substrate is placed.

The first exposure apparatus of the invention can also be arranged as follows: the exposure apparatus comprises a liquid supply mechanism which fills at least a portion of a space between the second diffraction grating and the substrate with a dielectric liquid having a refractive index of not less than 1.2 at a wavelength of the exposure.

The first exposure apparatus of the invention can also be arranged as follows: the exposure apparatus comprises a liquid supply mechanism which fills at least a portion of a space between the first diffraction grating and the second diffraction grating with a dielectric liquid having a refractive index of not less than 1.2 at the exposure wavelength.

A second exposure apparatus according to another aspect of the present invention is an exposure apparatus for effecting exposure on a photosensitive substrate, of an interference pattern generated by a diffraction grating formed in an optically-transparent flat plate, with illumination light from a light source, the exposure apparatus comprising: a holding mechanism which holds the diffraction grating formed in the optically-transparent flat plate, at a predetermined position; a substrate holding mechanism which holds the substrate in alignment at a position opposite to and in proximity to the diffraction grating; and an illumination optical system which applies the illumination light from the light source onto the diffraction grating, wherein a major portion of the illumination light applied onto an arbitrary point of the diffraction grating comprises a plurality of illumination light beams having respective traveling directions in at least one specific plane including a Y-direction, which is a specific direction in a plane on which the substrate is placed, and including the point, and the traveling directions are not parallel to each other.

The second exposure apparatus of the invention can also be arranged as follows: the illumination optical system comprises illumination light uniformizing means which substantially uniformizes an intensity distribution of the illumination light in a plane on which the diffraction grating is placed.
The illumination light uniformizing means can be one including at least one fly's eye lens in which lens elements are arrayed along the Y-direction.

Furthermore, the second exposure apparatus of the invention can also be arranged as follows: the illumination light uniformizing means comprises a condensing optical system which substantially limits illumination light incident to an arbitrary lens element in the at least one fly's eye lens, to illumination light distributed in a predetermined range in an X-direction perpendicular to the Y-direction, among illumination light distributed in a predetermined plane on the light source side with respect to the fly's eye lens in the illumination light uniformizing means.

The second exposure apparatus of the invention can also be arranged as follows: the specific plane is one plane substantially perpendicular to the plane on which the substrate is placed.
Alternatively, the second exposure apparatus of the invention can also be arranged as follows: the specific plane is one plane inclined at a predetermined angle of inclination relative to a direction of a normal to the plane on which the substrate is placed.

Moreover, the second exposure apparatus of the invention can also be arranged as follows: the specific plane is two planes inclined substantially in symmetry at a predetermined angle of inclination relative to a direction of a normal to the plane on which the substrate is placed.
The second exposure apparatus of the invention can also be arranged as follows: the exposure apparatus comprises a liquid supply mechanism which fills at least a portion of a space between the diffraction grating and the substrate with a dielectric liquid having a refractive index of not less than 1.2 at a wavelength of the exposure.

An illumination optical apparatus according to another aspect of the present invention is an illumination optical apparatus which applies illumination light from a light source onto a predetermined plane to be illuminated, wherein a major portion of the illumination light applied onto an arbitrary point of the plane to be illuminated comprises a plurality of illumination light beams having respective traveling directions in at least one specific plane including a Y-direction, which is a specific direction in the plane to be illuminated, and including the point, and the traveling directions are not parallel to each other.

The illumination optical apparatus of the invention can also be arranged as follows: the illumination optical apparatus comprises illumination light uniformizing means which substantially uniformizes an intensity distribution of the illumination light in the plane to be illuminated.
The illumination light uniformizing means can be one including at least one fly's eye lens in which lens elements are arrayed along the Y-direction.

Furthermore, the illumination optical apparatus of the invention can also be arranged as follows: the illumination light uniformizing means comprises a condensing optical system which substantially limits illumination light incident to an arbitrary lens element in the at least one fly's eye lens, to illumination light distributed in a predetermined range in an X-direction perpendicular to the Y-direction, among illumination light distributed in a predetermined plane in the illumination light uniformizing means.

The illumination optical apparatus of the invention can also be arranged as follows: the specific plane is one plane substantially perpendicular to the plane on which the substrate is placed.
Alternatively, the illumination optical apparatus of the invention can also be arranged as follows: the specific plane is one plane inclined at a predetermined angle of inclination relative to a direction of a normal to the plane on which the substrate is placed.
Moreover, the illumination optical apparatus of the invention can also be arranged as follows: the specific plane is two planes inclined substantially in symmetry at a predetermined angle of inclination relative to a direction of a normal to the plane on which the substrate is placed.

Brief Description of the Drawings

Fig. 1 is a drawing schematically showing an exposure apparatus of the present invention.

Fig. 2 is a drawing to illustrate an example of a first diffraction grating and a second diffraction grating G21, wherein (A) is a drawing showing the first diffraction grating G11, G12 formed on a first optically-transparent flat plate P1 and (B) is a drawing showing the second diffraction grating G21 formed on a second optically-transparent flat plate P2.

Fig. 3 is a sectional view showing a positional relation among the first diffraction grating G11, G12, the second diffraction grating G21, and a wafer W, and rays of diffracted light LP, LM, LP0, LP1.

Fig. 4 is a sectional view showing an intensity distribution of interference fringes formed on the wafer W.

Fig. 5 is a drawing to illustrate influence of deviation in an incidence angle of illumination light on positional deviation of the intensity distribution of interference fringes formed on the wafer W.

Fig. 6 is a drawing showing an example of illumination light uniformizing means, wherein (A) is a drawing showing a shape in the XY plane of input fly's eye lens 12, (B) is a drawing showing a shape in the XY plane of fly's eye lens 20, (C) is a drawing showing a side view from the + X-direction, and (D) is a drawing showing a side view from the - Y-direction.

Fig. 7 is a drawing showing incidence angle ranges of illumination light to the first optically-transparent flat plate, wherein (A) is a drawing showing a side view from the first + X-direction, (B) is a drawing showing a side view from the - Y-direction, and (C) is a drawing showing an aperture stop 28.

Fig. 8 is a drawing showing an example of secondary illuminant position correcting means.

Fig. 9 is a drawing showing another example of secondary illuminant position correcting means.

Fig. 10 is a drawing showing another example of the illumination light uniformizing means, wherein (A) is a drawing showing a side view from the + X-direction and (B) is a drawing showing a side view from the - Y-direction.

Fig. 11 is a drawing to illustrate an in-plane change in incidence angles of illumination light to the first optically-transparent flat plate.

Fig. 12 is a sectional view showing a positional relation among the first diffraction grating G11, G12, second diffraction grating G21, wafer W, and thin films PE1, PE2.

Fig. 13 is a drawing showing a state in which a protecting layer PE3 is provided near the second diffraction grating G21.

Fig. 14 is a drawing showing a state in which the first diffraction grating G15, G16 and second diffraction grating G23 are provided on two sides of the first optically-transparent flat plate P3, respectively.

Fig. 15 is a drawing showing a state in which a diffraction grating is provided on the wafer W side of an optically-transparent flat plate P4.

Fig. 16 is a drawing showing a part of another example of the illumination light uniformizing means, wherein (A) is a drawing showing a shape in the XY plane of input fly's eye lens 12a and (B) is a drawing showing shapes in the XY plane of fly's eye lenses 23L, 23R.

Fig. 17, together with Fig. 16, is a drawing showing another example of the illumination light uniformizing means, wherein (A) is a drawing showing a side view from the + X-direction and (B) is a drawing showing a side view from the - Y-direction.

Fig. 18 is a drawing showing a holding mechanism 36a for the first optically-transparent flat plate P1 and a holding mechanism 37a for the second optically-transparent flat plate P2.

Fig. 19 is a drawing showing a replacing mechanism 42 for the second optically-transparent flat plate P2, and others, wherein (A) is a bottom view thereof and (B) is a sectional view thereof at position A-B.

Fig. 20 is a drawing to illustrate a mechanism for filling a space between the wafer W and the second optically-transparent flat plate P2, and others with a liquid, wherein (A) is a drawing to illustrate a mechanism for filling only the space between the wafer W and the second optically-transparent flat plate P2 and (B) is a drawing to illustrate a mechanism for further filling a space between the optically-transparent flat plate P2 and the optically-transparent flat plate P1 with a liquid as well.

Fig. 21 is a drawing to illustrate a mechanism for filling the space between the optically-transparent flat plate P2 and the optically-transparent flat plate P1 with a liquid.

Description of Reference Symbols

1 light source; 2, 3, 5, 7 collimator lens; 11 condensing optical system; 20 fly's eye lens; 27 illumination aperture stop; 29, 30, 32, 35 illumination-system rear-group lenses; P1 first optically-transparent flat plate; P2 second optically-transparent flat plate; 36a, 36b first holding mechanism; 37a, 37b second holding mechanism; W substrate (wafer); 38 wafer stage; 40 laser interferometer; G11, G12, G15, G16 first diffraction grating; G21, G23 second diffraction grating; IL1-IL8 illumination light.

Best Mode for Carrying out the Invention

Embodiments of the present invention will be described below.

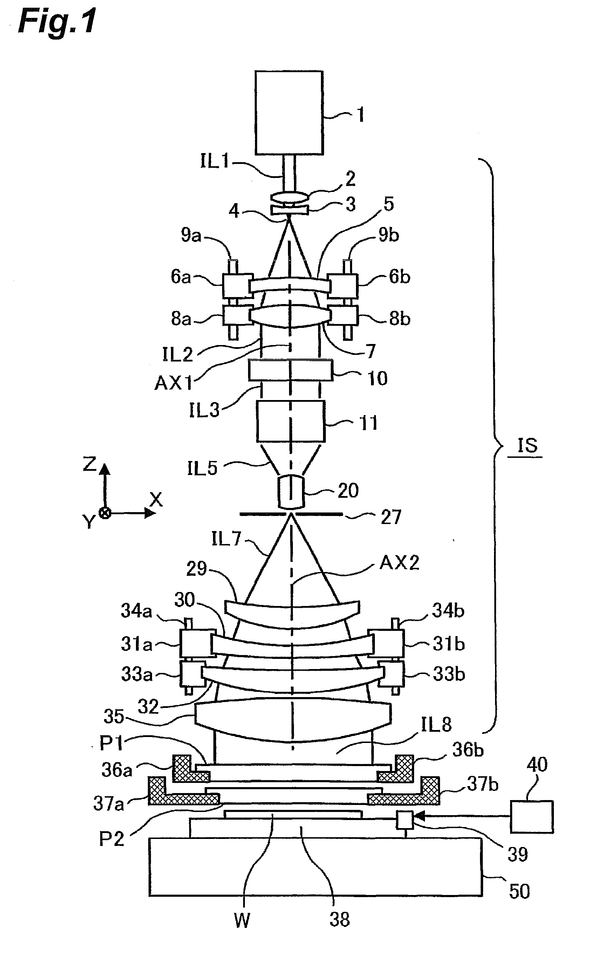

Fig. 1 is an overall view showing a first embodiment of the exposure apparatus according to the present invention. The XYZ coordinate system shown in Fig. 1 is the same as that shown in each of the drawings thereafter, and each of predetermined directions (X-direction, Y-direction, and Z-direction) indicates the same direction throughout the drawings.

Illumination light IL1 emitted from a light source 1, such as an ArF (argon-fluorine) excimer laser, a KrF (krypton-fluorine) excimer laser, an F2 (fluorine dimer) laser, or a harmonic laser using a wavelength conversion element, is converted into illumination light IL2 as a beam of parallel light rays (parallel beam) having a predetermined beam size, by a collimator lens group of lenses 2, 3, 5, 7 arranged along the first optical axis AX1.

The illumination light IL2 is converted into illumination light IL3 whose polarization is set in a predetermined polarization state, by a polarization control element 10, and the illumination light IL3 is then incident to a condensing optical system 11 forming a part of an illumination light uniformizing means. Then illumination light IL5 emerging from the condensing optical system 11 enters an optical integrator such as a fly's eye lens 20 forming a part of the illumination light uniformizing means.

An aperture stop 27 is located, if necessary, on the exit-side plane of the fly's eye lens 20.

The details of the illumination light uniformizing means consisting of the condensing optical system 11, fly's eye lens 20, aperture stop 27, etc. will be described later.

Illumination light IL7 emerging from the fly's eye lens 20 is then incident to illumination-system rear-group lenses 29, 30, 32, 35 arranged along the first optical axis AX2, is refracted by these lenses, and is then incident as illumination light IL8 to a first optically-transparent flat plate P1.

The optical members on the optical path of the illumination light IL1-IL8 from the above-described collimator lens group 2, 3, 5, 7 to the illumination-system rear-group lenses 29, 30, 32, 35 will be referred to hereinafter as an illumination optical system IS. This illumination optical system IS can also be regarded as an illumination optical apparatus a predetermined illumination plane of which is the plane where the first optically-transparent flat plate P 1 is placed.

A second optically-transparent flat plate P2 is provided below the first optically-transparent flat plate P1 (in the - Z-direction). The second optically-transparent flat plate P2 is arranged opposite to and in proximity to a substrate W (hereinafter also referred to as a wafer on an as-needed basis) such as a semiconductor wafer which is a processed object in which a pattern is to be formed.

A first diffraction grating described below is formed in the first optically-transparent flat plate P1 and when the illumination light IL8 is applied onto the first diffraction grating, diffracted light is generated thereby and is applied onto the second optically-transparent flat plate P2. A second diffraction grating described below is formed in the second optically-transparent flat plate P2 and the diffracted light is applied onto the second diffraction grating. Diffracted light generated by the second diffraction grating is applied onto the wafer W whereby a light-dark pattern of interference fringes composed of a plurality of diffracted light beams is formed on the wafer W.

A photoresist for the light-dark pattern to be printed and recorded is formed on the surface of the wafer W. Namely, the wafer W can be regarded as a photosensitive substrate.

The wafer W is held on a wafer stage 38 as a substrate holding mechanism movable in the XY directions on a wafer platen 50, whereby it is movable in the XY directions. The X-directional position of the wafer W is measured by a laser interferometer 40 through a position of a moving mirror 39 provided on the wafer stage 38, and the Y-directional position thereof is also measured by an unrepresented laser interferometer through a position of an unrepresented moving mirror provided on the wafer stage 38.

The second optically-transparent flat plate P2 is held by a second holding mechanism 37a, 37b so as to be arranged opposite to and in proximity to the wafer W with a predetermined distance described below. The first optically-transparent flat plate P1 is held by a first holding mechanism 36a, 36b so as to be arranged opposite to the second optically-transparent flat plate P2 with a predetermined distance described below.

The wafer W has, for example, the diameter of 300 mm, and the second optically-transparent flat plate P2 has the diameter enough to cover the entire surface of the front face of the wafer W as an example. Likewise, the first optically-transparent flat plate P1 also has the diameter enough to cover the entire surface of the front face of the second optically-transparent flat plate P2 as an example. It is, however, preferable, as described below, that the diameter of the first optically-transparent flat plate P1 be at least about 30 mm larger than the diameter of the wafer W.

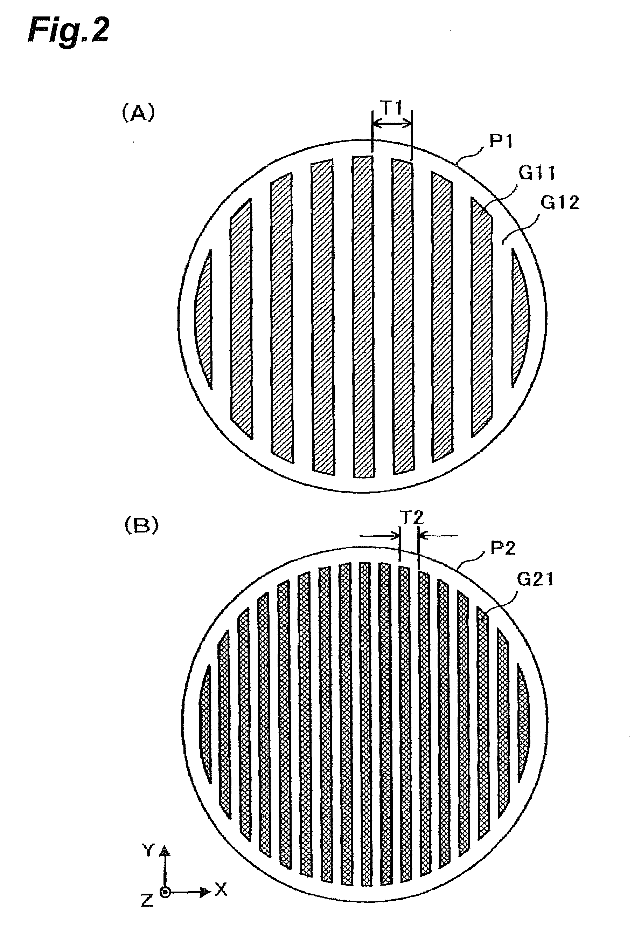

The light-dark pattern of interference fringes formed on the wafer W according to the present invention will be described below with reference to Figs. 2, 3, 4, and 5.

A one-dimensional phase modulation type diffraction grating G1 1, G12 with periodicity in the X-direction is formed on the surface on the + Z-side, i.e., on the light source side of the first optically-transparent flat plate P1. On the other hand, a one-dimensional intensity modulation type diffraction grating G21 with periodicity in the X-direction is formed on the surface on the - Z-side, i.e., on the wafer W side of the second optically-transparent flat plate P2.

First, these diffraction gratings G11, G12, G21 will be described referring to Fig. 2.

Fig. 2 (A) is a view of the first optically-transparent flat plate P1 from the + Z-side, and the phase modulation type first diffraction grating G11, G12, which has the longitudinal direction along the Y-direction and the one-dimensional period T1 in the X-direction perpendicular to it, is formed on the surface of the plate P 1. The first diffraction grating G11, G12 is composed of surface portions G12 of the first optically-transparent flat plate P1, and indentations G11 formed by engraving the surface of the flat plate by etching or the like, like a so-called chromeless phase shift reticle. The depth of the indentations G11 is so set that the phase difference of 180° is made between illumination light transmitted by the surface portions G12 and illumination light transmitted by the indentations G12. The depth of the indentations is defined as (2m - 1)λ0/(2(n - 1)), where λ0 is the wavelength of exposure light, n the refractive index of the first optically-transparent flat plate P1, and m an arbitrary natural number.

A ratio of widths of the surface portions G12 and indentations G11 (duty ratio) is preferably set to 1:1.

Fig. 2 (B) is a view of the second optically-transparent flat plate P2 from the + Z-side, and the second diffraction grating G21, which has the longitudinal direction along the Y-direction and the one-dimensional period T2 in the X-direction, is formed on the back surface of the plate P2 (the surface on the wafer W side). The second diffraction grating G21 is a grating comprised of a film of a material selected from metals such as chromium, molybdenum, tungsten, and tantalum, oxides, fluorides, or silicides thereof, and other light-shielding or light-reducing materials.

The first optically-transparent flat plate P1 and the second optically-transparent flat plate P2 are made of a material that is highly transparent to ultraviolet light, which has a small coefficient of thermal expansion (linear expansion coefficient), and that thus undergoes less thermal deformation with absorption of the exposure light, such as synthetic silica. Particularly, where the F2 laser is used as the light source 1, a preferred material is synthetic silica doped with fluorine.

In Fig. 2 (A) and (B), for convenience' sake of description, the period T1 is illustrated as if to be approximately 10% of the diameter of the first optically-transparent flat plate P1 (300 mm or more as an example), but in fact the period T1 is, for example, approximately 240 nm and the period T2, for example, approximately 120 nm, which are overwhelmingly smaller than the diameter of the first optically-transparent flat plate P1. This is also the case in each of the drawings other than Fig. 2 (A) and (B).

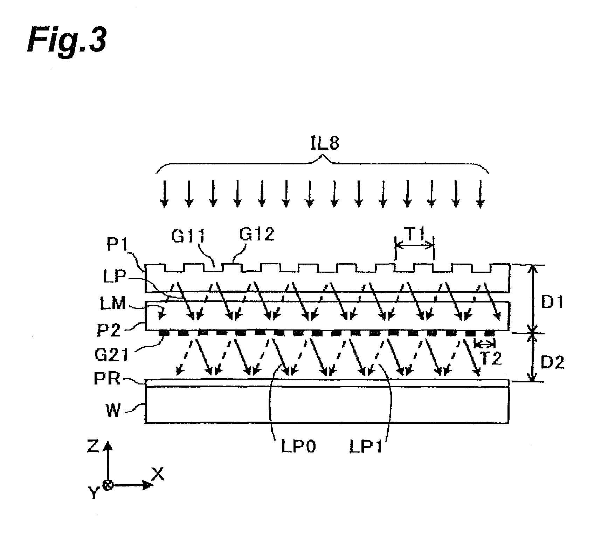

The following will describe, referring to Fig. 3, how the light-dark pattern of interference fringes is formed on the wafer W with application of the illumination light IL8 onto the first diffraction grating G11, G 12 and the second diffraction grating G21.

Fig. 3 is a drawing showing cross sections of the first optically-transparent flat plate P1, the second optically-transparent flat plate P2, and the wafer W arranged opposite to each other.

When the illumination light IL8 is applied, the first diffraction grating G11, G12 generates diffracted light according to the period T1. When the first diffraction grating G11, G12 is a phase modulation type grating with the duty ratio of 1:1 and the phase difference of 180°, no zero-order diffracted light appears. In this case mainly two beams of ± first-order diffracted light appear, and higher-order diffracted light such as ± second-order diffracted light can also appear.

However, when the period T1 is shorter than three times the effective wavelength λ of the illumination light, no higher-order diffracted light of third and higher orders can be produced. When the diffraction grating is the phase modulation type grating with the duty ratio of 1:1 and the phase difference of 180° as described above, no second-order diffracted light can be produced, either. In this case, therefore, only two beams of + first-order diffracted light LP and - first-order diffracted light LM are generated from the first diffraction grating G11, G12, and they travel through the first optically-transparent flat plate P 1 to enter the second optically-transparent flat plate P2.

The effective wavelength λ of the illumination light herein refers to the wavelength of the illumination light in a medium with a minimum refractive index among optically-transparent media existing on the illumination optical path from the first diffraction grating G11, G12 to the wafer W. In this example, air (or nitrogen or rare gas) exists in each of spaces between the optically-transparent flat plate P1 and the optically-transparent flat plate P2 and between the optically-transparent flat plate P2 and the wafer W, and thus the effective wavelength λ0 is a value obtained by dividing the wavelength λ0 of the illumination light by the refractive index of air (= 1).

Subsequently, the beams of + first-order diffracted light LP and - first-order diffracted light LM are applied onto the second diffraction grating G21 provided on the surface on the wafer W side of the second optically-transparent flat plate P2. Since the two diffracted light beams are symmetric, the description below will concern only the + first-order diffracted light LP.

The + first-order diffracted light LP is incident at a predetermined angle of inclination from the direction perpendicular to the second diffraction grating G21 (i.e., from the direction of a normal thereto), depending upon the period T1 of the first diffraction grating G11, G12, to the second diffraction grating G21.

Assuming that the second diffraction grating G21 is located in air, the angle θ0 of inclination is an angle represented by (Formula 1) below:

## (Formula 1)

$$\sin\theta0 = \lambda/T1.$$

When the + first-order diffracted light LP is applied onto the second diffraction grating G21, the second diffraction grating G21 also generates diffracted light. Since the second diffraction grating G21 is an intensity modulation type diffraction grating, the diffracted light is diffracted light containing the zero-order light.

Angular directions in which the respective beams of diffracted light are generated herein are inclined according to the inclination of the angle of incidence of the applied illumination light (+ first-order diffracted light LP). Namely, the second diffraction grating G21 generates the zero-order diffracted light LP0 traveling in the direction parallel to the applied + first-order diffracted light LP, and the - first-order diffracted light LP1 diffracted according to the X-directional period T2 of the second diffraction grating G21.

If the period T2 of the second diffraction grating G21 is larger than a predetermined value determined from the relationship with the period T1 and the effective wavelength, the + first-order diffracted light not shown can also be generated. However, the generation of the unrepresented + first-order diffracted light can be substantially prevented by setting the period T2 to a value not more than the effective wavelength of the illumination light. The effective wavelength $\lambda$ of the illumination light herein is the one as defined above.

As a result, two diffracted light beams of the zero-order diffracted light LP0 and the - first-order diffracted light LP1 are applied onto the wafer W, whereby a light-dark pattern of interference fringes is formed based on interference of those diffracted light beams.

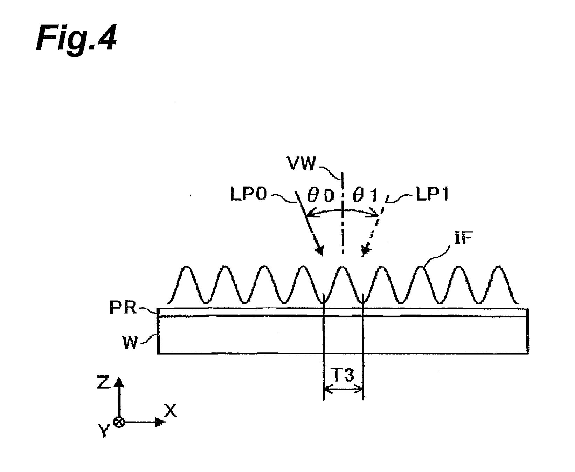

This light-dark pattern of interference fringes will be described below with reference to Fig. 4.

Fig. 4 is a sectional view showing the light-dark profile of interference fringes formed on the wafer W by the two diffracted light beams of the zero-order diffracted light LP0 and the - first-order diffracted light LP1.

Since the zero-order diffracted light LP0 is generated in the direction parallel to the + first-order diffracted light LP applied onto the second diffraction grating G21 as described above, the zero-order diffracted light LP0 is applied at the afore-mentioned incidence angle $\theta0$ of inclination with respect to the vertical direction (normal direction) ZW to the wafer W.

On the other hand, the - first-order diffracted light LP1 is diffracted in the X-direction by the X-directional period T2 and is applied at the incidence angle $\theta1$ to the wafer W. The period (period of intensity distribution) T3 of the light-dark pattern of interference fringes IF formed on the wafer W at this time is given by (Formula 2) below:

## (Formula 2)

$$T3 = \lambda/(\sin\theta0 + \sin\theta1).$$

This corresponds to a half of the period of the amplitude distribution of interference fringes IF.

Therefore, the light-dark pattern parallel to the Y-direction with the period T3 in the X-direction is formed over the entire surface of the wafer W. Then the photoresist PR formed on the wafer W is illuminated with and exposed to this light-dark pattern.

In general, interference fringes formed by two rays like the interference fringes IF are a light-dark pattern with extremely small reduction in contrast even with Z-directional positional variation of the wafer W, i.e., a light-dark pattern with a large so-called depth of focus.

However, if the incidence angle $\theta0$ of the zero-order diffracted light LP0 is not equal to the incidence angle $\theta1$ of the - first-order diffracted light LP1 (i.e., if they are not symmetric with respect to the normal direction VW), there will be variation in the X-directional position of interference fringes IF according to Z-directional positional deviation of the wafer W.

Therefore, if one desires to accurately control the X-directional position of interference fringes IF, the incidence angle $\theta0$ of the zero-order diffracted light LP0 applied onto the wafer W should be set so as to be equal to the incidence angle $\theta1$ of the -first-order diffracted light LP1. This condition is realized when the period T1 of the first diffraction grating G11, G12 is approximately double the period T2 of the second diffraction grating G21, on the assumption that the illumination light IL8 is incident normally to the first diffraction grating G11, G12. At this time, the relation of (Formula 3) below is satisfied:

(Formula 3)

$$T2 = T3.$$

Since both of the first diffraction grating G11, G12 and the second diffraction grating G21 include a manufacturing error or the like, it cannot be expected in practice that the periods of the two gratings are precisely double. Therefore, "approximately double" above means that it is generally good for the two periods to satisfy the condition of (Formula 4) below.

(Formula 4)

$$T2 \times 2 \times 0.999 \le T1 \le T2 \times 2 \times 1.001.$$

When the above condition is satisfied, the light-dark pattern of interference fringes IF can be applied to a predetermined position of the wafer W even if there occurs a positional deviation in the Z-direction of the wafer W.

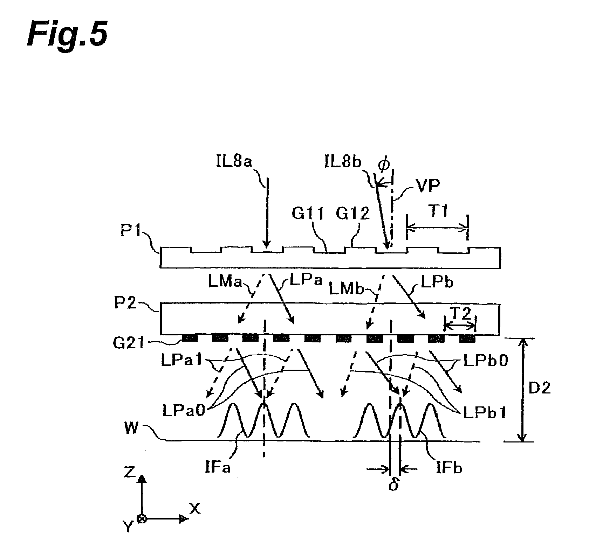

It is noted herein that the condition indicated by Formula 4 above does not always have to be satisfied as long as the Z-directional position of the wafer W can be precisely controlled at a predetermined position.
It is necessary as described above that the illumination light IL8 be incident, for example, normally to the first diffraction grating G11, G12. The following will describe the reason for it, and a more precise condition for the incidence angle with reference to Fig. 5.

Fig. 5, similar to Figs. 3 and 4, is a drawing showing cross sections of the first optically-transparent flat plate P1, the second optically-transparent flat plate P2, and the wafer W, and interference fringes IFa, IFb formed on the wafer W. The period T1 of the first diffraction grating G11, G12 herein is assumed to be double the period T2 of the second diffraction grating G21.

The interference fringes IFa on the left side in Fig. 5 indicate interference fringes formed by the illumination light IL8a incident normally to the first diffraction grating G11, G12. In this case, as in the case shown in Figs. 3 and 4, the first diffraction grating G11, G12 generates + first-order diffracted light LPa and - first-order diffracted light LMa in symmetry, and these beams are incident to the second diffraction grating G21. When attention is focused on the + first-order diffracted light LPa among them, beams of zero-order diffracted light LPa0 and -first-order diffracted light LPa1 generated from the second diffraction grating G21 are incident at an equal angle of incidence (as inclined in symmetry) to the wafer W.

Therefore, the interference fringes IFa with the period T2 of light and dark portions (intensity) in the X-direction are formed at a predetermined position on the wafer W. Then X-directional positions of peaks of the light portions accurately correspond to the positions of the transparent portions of the second diffraction grating G21.

On the other hand, interference fringes IFb on the right side in Fig. 5 indicate interference fringes formed by illumination light IL8b incident at an angle φ of incidence toward the X-direction to the first diffraction grating G11, G12. In this case, the first diffraction grating G11, G12 also generates + first-order diffracted light LPb and - first-order diffracted light LMb, but the angular symmetry thereof is broken according to the inclination of the incidence angle of the illumination light IL8b.

This results in also breaking the symmetry of incidence angles of the zero-order diffracted light LPb0 and the - first-order diffracted light LPb1 generated from the second diffraction grating G21, to the wafer W with application of the + first-order diffracted light LPb among them.
Even in this case, interference fringes IFb with the period T2 of light and dark portions (intensity) in the X-direction are also formed on the wafer W, but the X-directional positions of peaks of the light portions are shifted from the positions of the transparent portions of the second diffraction grating G21.

When the shift amount is defined as δ, it is represented by the relation of (Formula 5) below:

(Formula 5)

$$\delta = D2 \times \tan\varphi.$$

In this equation, D2 is a distance between the second diffraction grating G21 and the surface of the wafer W.

If the illumination light incident to the first diffraction grating G11, G12 is only IL8b inclined toward the X-direction, the positions of the interference fringes formed on the wafer W are shifted in the X-direction, but no reduction is made in the contrast thereof.

However, if the illumination light incident to the first diffraction grating G11, G12 is beams of illumination light having a plurality of traveling directions at different inclination angles (incidence angles) toward the X-direction, the positions of interference fringes formed by those beams of illumination light are also different from each other from Formula 5, and the contrast is reduced for the interference fringes formed finally by intensity superposition of the interference fringes.

Therefore, in order to avoid the above-described reduction in contrast, the X-directional incidence angle of illumination light IL8 incident to at least one point on the first diffraction grating G11, G12 needs to be a certain fixed value.

For example, when the period T3 (= T2) of the interference fringe pattern for exposure on the wafer W is 120 nm, i.e., when the pattern is a pattern generally called a 60nm line-and-space pattern, influence of the contrast reduction as a whole of the interference fringe pattern can be kept sufficiently low if the variation in the X-directional position caused by variation in the X-directional inclination angle of illumination light IL8 is within approximately $\pm$ 15 nm.

Therefore, where the distance D2 between the second diffraction grating G21 and the surface of the wafer W is 50 [$\mu$m], an allowable angular range $\varphi$0 of the variation in the X-directional inclination angle of the illumination light IL8 can be calculated as in Formula 6 below as an example, in accordance with Formula 5:

$$(\text{Formula 6})$$

$$\varphi 0 = \arctan(15/50000) = 0.3 \ [\text{mrad}].$$

It is, however, needless to mention that this condition varies depending upon the period T3 of the pattern to be transferred and the distance D2.

On the other hand, Y-directional inclination of the incidence angle of illumination light IL8 causes a change in the Y-directional positions of the interference fringes IF on the wafer W, but the interference fringes IF are interference fringes approximately uniform in the Y-direction, according to the shapes of the first diffraction grating G11, G12 and the second diffraction grating G21 in the XY plane; therefore, the Y-directional position change thereof causes no problem at all.

Namely, the Y-directional inclination of the incidence angle of illumination light IL8 causes no substantial positional deviation of the interference fringes IF, and no reduction in the contrast of the interference fringes IF even if the illumination light IL8 is beams of illumination light having a plurality of traveling directions with different inclination angles to the Y-direction.

Therefore, the illumination light IL8 applied to an arbitrary point on the first diffraction grating G11, G12 needs to be illumination light that may have a plurality of incidence angles in the Y-direction, but that has a single predetermined incidence angle in the X-direction.

In other words, the illumination light IL8 applied onto an arbitrary point of the first diffraction grating needs to be illumination light that has traveling directions within a plane including the Y-direction and the point of interest (which will be referred to as a specific plane).

The illumination light IL8 may be illumination light consisting of a plurality of illumination light beams having different traveling directions not parallel to each other, as long as the traveling directions are within the specific plane. They may also deviate from the specific plane as long as the X-directional incidence angle range, or the angular range of traveling directions is within about $\pm$ 0.3 [mrad] as described above.

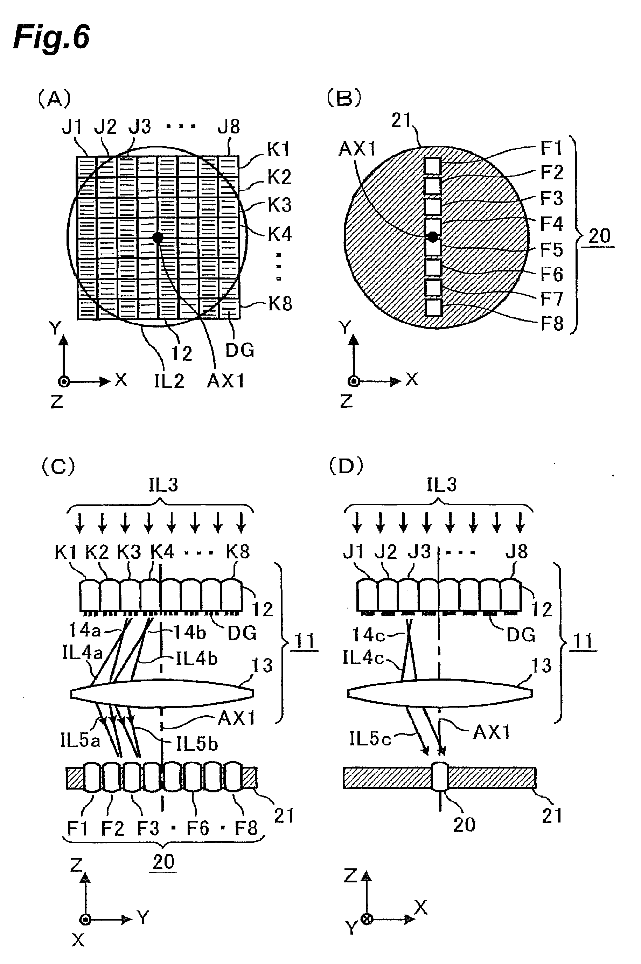

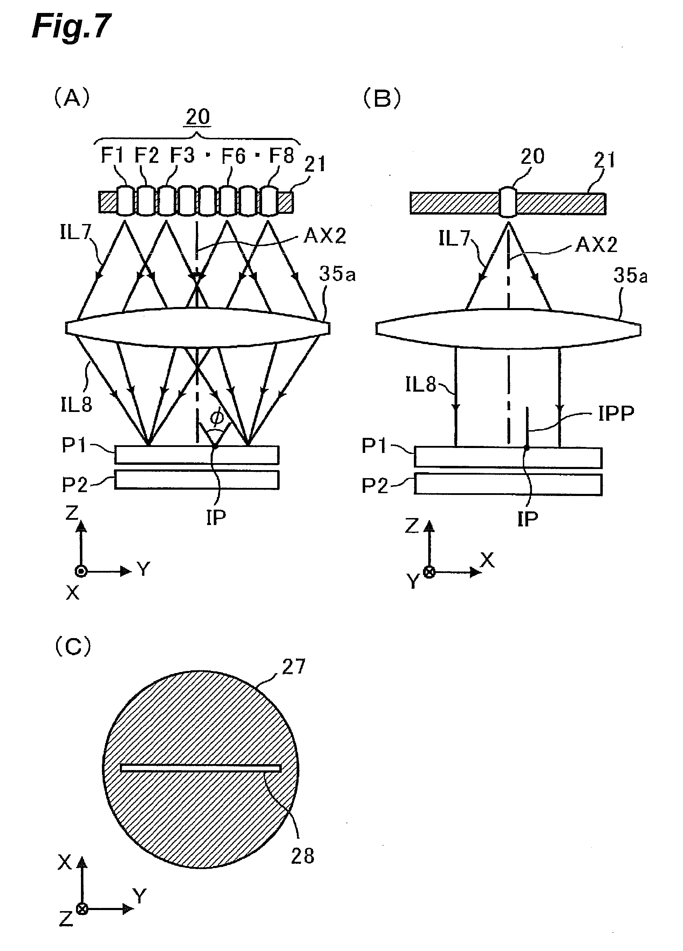

An example of the illumination light uniformizing means for implementing the illumination light IL8 satisfying the above condition will be described below with reference to Figs. 6 and 7.

Fig. 6 (C) is a side view of the illumination light uniformizing means from the + X-direction, and Fig. 6 (D) a side view of the illumination light uniformizing means from the - Y-direction.

The illumination light uniformizing means of this example consists of a condensing optical system 11 consisting of an input fly's eye lens 12 and a condenser lens 13, and a fly's eye lens 20 in which lens elements F1, F2, F3, F4, F5, F6, F7, and F8 are arrayed on a line along the Y-direction on a light-shielding member 21.

Fig. 6 (A) is a view of the input fly's eye lens 12 from the + Z-direction, and Fig. 6 (B) a view of the fly's eye lens 20 from the + Z-direction.

The input fly's eye lens 12 is, for example, one consisting of sixty four lens elements, while having eight lines of lens elements J1, J2, J3, J4, J5, J6, J7, J8 (among which reference symbols J4 to J7 are omitted from illustration) in the X-direction and eight lines of lens elements K1, K2, K3, K4, K5, K6, K7, K8 (among which reference symbols K5 to K7 are omitted from illustration) in the Y-direction as well.

When the illumination light IL2 is applied onto the input fly's eye lens 12, the illumination light impinges upon each lens element of the array on the fly's eye lens 20 as described below. Then the illumination light IL7 emerging from the fly's eye lens 20 is incident to the illumination-system rear-group lens 35a, as shown in Fig. 7(A) and (B), and is refracted by these lenses to be incident as illumination light IL8 to the first optically-transparent flat plate P1.

However, since the fly's eye lens 20 is composed of the plurality of lens elements F1-F8 arranged on a line along the Y-direction, incidence angle characteristics of the illumination light IL8 to the first optically-transparent flat plate P1 are different between in the X-direction and in the Y-direction.

Fig. 7 (A) is a view from the + X-direction of the fly's eye lens 20, the illumination-system rear-group lens 35a, the first optically-transparent flat plate P1, and the second optically-transparent flat plate P2, and Fig. 7 (B) is a view from the - Y-direction thereof. The illumination-system rear-group lenses are represented by the single lens 35a for simplicity, but it is needless to mention that it is actually equivalent to the illumination-system rear-group lenses 29, 30, 32, 35 in Fig. 1.

The illumination-system rear-group lens 35a is located so that its entrance focal plane coincides with the exit surface of the fly's eye lens 20 and that its exit focal plane coincides with the top surface (+ Z) of the first optically-transparent flat plate P1. Therefore, the illumination-system rear-group lens 35a also constitutes a so-called Fourier transform lens.

Beams of illumination light IL7 emerging from the respective lens elements of the fly's eye lens 20 are refracted by the illumination-system rear-group lens 35a and are applied as illumination light IL8 in a superposed manner onto the first optically-transparent flat plate P1. Therefore, an intensity distribution of illumination light on the first optically-transparent flat plate P1 is more uniformized by an averaging effect of the superposition.

The incidence angle range φ in the Y-direction of the illumination light IL8 to an arbitrary point IP on the first optically-transparent flat plate P1 is a predetermined value as shown in Fig. 7 (A) according to the array in the Y-direction of the fly's eye lens 20.

On the other hand, since the fly's eye lens 20 includes only one line in the X-direction, the incidence angle range in the X-direction can be approximately 0.

Namely, the illumination light IL8 to one point IP can be a plurality of illumination light beams having respective traveling directions in a plane including the Y-direction and including the point IP (i.e., in the aforementioned specific plane), EPP, and the traveling directions are not parallel to each other.

By limiting the traveling directions of the illumination light IL8 among others to within the plane of the specific plane IPP, it becomes feasible to prevent the reduction in contrast of the interference fringes on the wafer W and to obtain an interference fringe pattern with higher contrast, as described above.

When the illumination light IL8 is composed of a plurality of illumination light beams not parallel to each other, the aforementioned averaging effect achieves uniformization of the intensity distribution of illumination light on the first optically-transparent flat plate P1.

It is a matter of course that the application range of the illumination light IL8 does not always have to embrace the entire surface of the first optically-transparent flat plate P 1. Namely, the point is that the illumination is achieved so that the intensity distribution of the illumination light IL8 is uniform in a predetermined region including the center portion of the first diffraction grating G11, G12 formed on the first optically-transparent flat plate P1 and letting transmitted illumination light reach the wafer W.

In another potential example, an aperture stop 27 with an aperture 28 of a slit shape long in the Y-direction and narrow in the X-direction as shown in Fig. 7 (C) is provided on the exit surface of the fly's eye lens 20, if necessary, and it further limits the traveling directions in the X-direction of the illumination light IL8 to within a plane parallel to the specific plane IPP.

A configuration of the input fly's eye lens 12 will be described below in detail.

Illumination light IL3 impinging upon each lens element forming the input fly's eye lens 12 is converged by the lens action of each lens element. Preferably, a blazed or multistep type diffraction grating DG, which deflects the illumination light in the Y-direction, is formed on an exit surface of each lens element. The diffraction gratings DG formed on the lens elements arrayed at the same X-directional array position in the input fly's eye lens 12 are supposed all to have the same diffraction angle characteristic.

Therefore, the illumination light emerging from each lens element at the Y-directional array positions K1-K8 is subjected to the converging action of each lens element and the diffraction (deflection) action in the Y-direction by the diffraction grating DG.

Fig. 6 (C) and Fig. 6 (D) show illumination light beams IL4a, IL4b emerging from the Y-directional array positions K3 and K4 at the X-directional array position J3 (which will be totally referred to as IL4c) as an example. As illustrated, the illumination light beams IL4a, IL4b, IL4c exit from the lens elements and are then once converged at converging points 14a, 14b, 14c. Then the light beams are incident to the condenser lens 13 so arranged that the entrance focal plane thereof coincides with the converging points 14a, 14b, 14c and that the exit focal plane coincides with the entrance surface of the fly's eye lens 20. Namely, the condenser lens 13 constitutes a so-called Fourier transform lens. The entrance surface of each lens element of the input fly's eye lens 12 is in a conjugate relation (imaging relation) with an entrance surface of each lens element of the fly's eye lens 20 corresponding thereto.

Therefore, incidence positions to the fly's eye lens 20, of the respective illumination light beams IL4a, IL4b emerging from the respective lens elements K1-K8 (which will be totally referred to as IL4c) are as follows. Since each illumination light IL4c has no deflection angle in the X-direction upon exiting from the lens element K1-K8, the X-directional position thereof is near the optical axis AX1 as shown in Fig. 6 (D).

On the other hand, since each illumination light IL4a, IL4b has a predetermined deflection angle in the Y-direction upon exiting from the lens element K1-K8 because of the diffraction grating DG, the Y-directional position thereof is decentered in the Y-direction from the optical axis AX1 by an amount proportional to the deflection angle, as shown in Fig. 6 (C), and therefore the illumination light beams are applied to the lens element F3.

Since the deflection angles in the Y-direction of the respective illumination light beams emerging from the respective lens elements K1-K8 arrayed on the X-directional array position J3 are the same, as described above, the illumination light beams emerging from the respective lens elements K1-K8 all are applied in a superposed manner to the lens element F3.

Then the illumination light quantity distribution on the entrance surface of the lens element F3 is averaged and approximately uniformized by the superposition effect.

The deflection characteristics of the diffraction gratings DG formed on the exit surfaces of the respective lens elements of the input fly's eye lens 12 are identical at the same X-directional array position, but they are different at the X-directional array positions thereof different from each other. Therefore, illumination light beams emerging from the respective lens elements at the same X-directional array position on the input fly's eye lens 12 all are incident in a superposed manner to the same lens element on the fly's eye lens 20, and illumination light quantity distributions thereof on the entrance surface are averaged and approximately uniformized by the superposition effect.

The input fly's eye lens 12 and condenser lens 13 can also be regarded as an optical system for limiting the illumination light beams incident to one lens element on the fly's eye lens 20, to illumination light distributed in a predetermined range in the X-direction, among the illumination light distributed in the predetermined plane on which the input fly's eye lens 12 is placed.

The illumination light distributed in the predetermined range in the X-direction on the input fly's eye lens 12 is incident at a predetermined angle of inclination in the X-direction to the predetermined lens element (e.g., F3) on the fly's eye lens 20. Since the lens element F3 is also a Fourier transform lens, a converging point (secondary light source) of these illumination light beams formed on the exit surface of the fly's eye lens 20 is shifted in the X-direction according to the predetermined incidence angle in the X-direction.

The incidence angles in the X-direction of the illumination light beams incident to the respective lens elements F1-F8 are different from each other as described above, and thus the positions of the secondary light sources formed on the exit surface of the fly's eye lens 20 are shifted by a small amount in the X-direction for each of the lens elements F1-F8, and they are not formed on the same X-coordinate.

This X-directional variation in the positions of the respective secondary light sources will cause variation in the traveling directions in the X-direction of the respective illumination light beams forming the illumination light IL8, and, if a value of this variation is, for example, over the aforementioned tolerance (e.g., $\pm$ 0.3 [mrad]), it can also be a cause to lower the contrast of interference fringes formed on the wafer W.

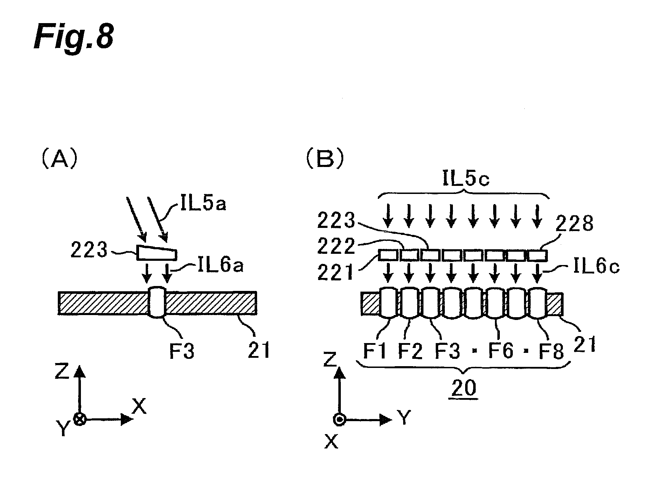

In order to cancel out this small shift, as shown in Fig. 8 (A) and Fig. 8 (B), the system may be provided with wedge prisms 221, 222, 223, 228 for deflecting the illumination light IL5a in the X-direction to align their traveling directions within the YZ plane, near the entrance surfaces of the respective lens elements F1-F8. Of course, wedge angles of the respective wedge prisms are angles different from each other.

This permits the illumination light IL6a to be incident normally in the X-direction to each lens element F1-F8 and permits the secondary light source group formed on the exit portios of the respective lens elements F1-F8 to be arrayed on the same X-coordinate.

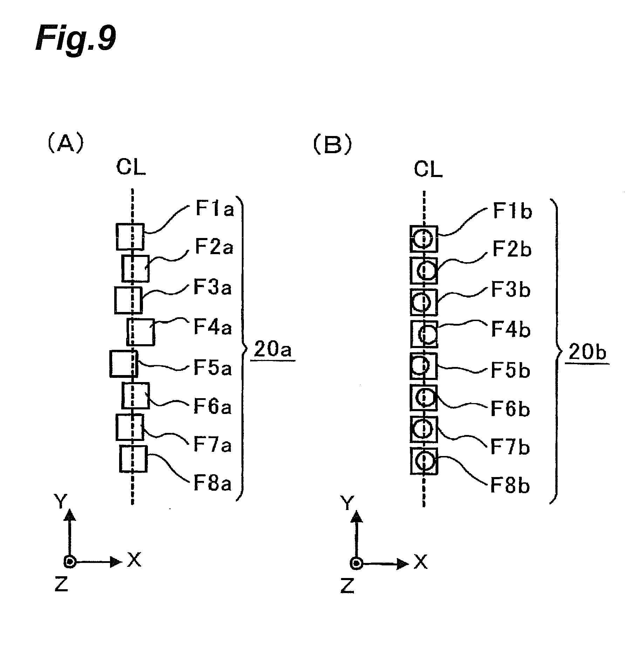

Alternatively, it is also possible to adopt another configuration, as shown in Fig. 9 (A), wherein the array is so arranged that each of lens elements F1a-F8a forming the fly's eye lens 20 is shifted by a small amount in the X-direction, whereby the secondary light source group formed on the exit surfaces thereof is formed on the same X-coordinate, i.e., on a dashed line CL in the drawing.

It is also possible to adopt still another configuration, as shown in Fig. 9 (B), wherein each of lens elements F1b-F8b forming the fly's eye lens 20 is composed of a lens whose lens center (center of each circle shown in the drawing) is deflected with respect to its contour, whereby the secondary light source group formed on the exit surfaces thereof is formed on the same X-coordinate, i.e., on a dashed line CL in the drawing.

The above means can reduce the X-directional variation in the secondary light source positions and reduce the X-directional variation in the traveling directions of the respective illumination light beams forming the illumination light IL8, to below the predetermined tolerance.

Such correction for the X-directional positions of the secondary light source group can be readily made because the illumination light incident to one of the lens elements F1-F8 forming the fly's eye lens 20 is limited to the illumination light distributed in the predetermined range in the X-direction, among the illumination light distributed in the predetermined plane where the input fly's eye lens 12 is placed, i.e., because it is limited to the illumination light within certain incidence angles in the X-direction.

It is, however, noted that the above limitation does not always have to be perfect. The reason is that substantially the same effect can be achieved as long as most of the illumination light out of the illumination light incident to one of the lens elements F1-F8 is the illumination light distributed in the predetermined range in the X-direction, among the illumination light distributed in the predetermined plane where the input fly's eye lens 12 is placed.

Since the diffraction gratings DG placed on the exit surface of the input fly's eye lens 12 also generate some stray light such as unwanted diffracted light, it can be said that it is difficult to perfectly prevent such stray light from entering the lens elements other than the desired one out of the lens elements F1-F8.

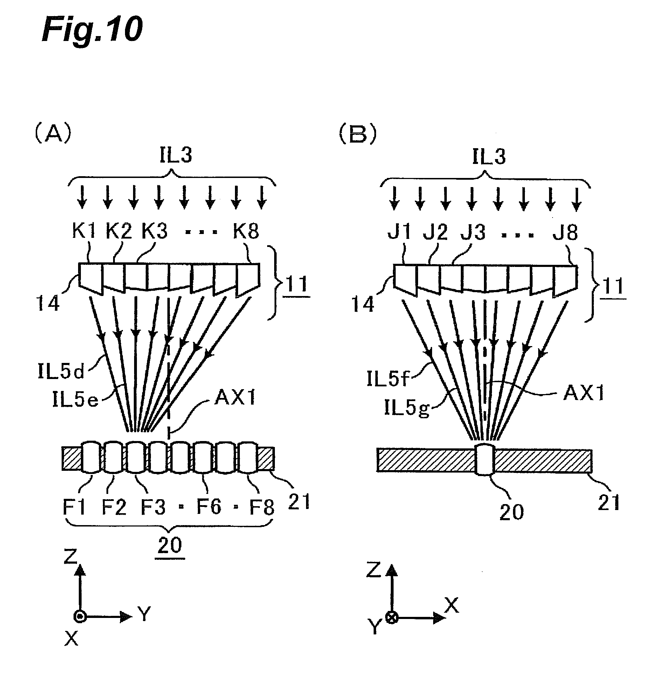

Examples of the condensing optical system 11 do not always have to be limited to this example, but it is also possible to adopt a prism array 14 in which taper angles of prism lenses are different from each other in a predetermined region in the XY plane, for example, as disclosed in Fig. 10.

The structure in the XY plane of the prism array 14 is one in which, for example, square prisms are two-dimensionally arrayed in the XY directions, as in the case of the input fly's eye lens 12 shown in Fig. 6 (A), but its cross section is one as shown in Fig. 10 (A) and Fig. 10 (B), in which the taper angles of the respective prisms vary according to the positions J1-J8 in each X-directional array and the positions K1-K8 in each Y-directional array.

The illumination light IL3 incident to the prism array 14 is subjected to the refraction action or deflection action according to the taper angles, and is applied onto the predetermined lens elements F1-F8 on the fly's eye lens 20.

It is also needless to mention that in the present example the illumination light incident to one of the lens elements F1-F8 is preferably limited to illumination light from a prism group arrayed at the same X-directional array position on the prism array 14. The reason is that this arrangement permits us to readily adopt the techniques shown in Figs. 8 and 9, for forming the secondary light source group on the exit surface of the fly's eye lens 20, on the same X-coordinate.

Now, let us discuss the angular relation between the specific plane and the direction of the normal to the plane on which the first diffraction grating G11, G12 is placed.

When the angular relation varies depending upon positions of respective points in the plane of the first diffraction grating G11, G12, i.e., when the inclination angle in the X-direction of the illumination light IL8 varies depending upon positions of respective points, the positional deviation in the X-direction of the interference fringes formed on the wafer W also varies depending upon the positions of the respective points, i.e., depending upon positions of respective points on the wafer W.

This is a problem similar to distortion in the projection exposure apparatus and can be a cause of position alignment failure with an existing pattern on the wafer W.

Therefore, the illumination light IL8 applied onto the first diffraction grating G11, G12, i.e., onto the first optically-transparent flat plate P1 is preferably incident at a constant value of the incidence angle to the X-direction, irrespective of locations in the first optically-transparent flat plate P1; i.e., the X-directional inclination angle of the specific plane relative to the direction of the normal to the plane on which the first diffraction grating G11, G12 is placed, is preferably constant independent of the locations of the respective points in the plane of the first diffraction grating G11, G12.

In the practical exposure apparatus, however, it is difficult to make the inclination angle perfectly constant independent of the positions of the respective points. In practice, therefore, practically satisfactory position alignment can be achieved if the inclination angle is within the tolerance described below, independent of the positions of the respective points.

When the interference fringe pattern for exposure on the wafer W is a 60nm line-and-space pattern, the tolerance for the positional deviation is generally approximately 15 nm, a quarter of the line width. Therefore, when the distance D2 between the second diffraction grating G21 and the surface of the wafer W is 50 [μm], the tolerance $\varphi 1$ for the variation in the inclination angle of the specific plane varying depending upon the positions of the respective points, is calculated, for example, as in the following Formula 7:

$$(\text{Formula 7})$$

$$\varphi 1 = \arctan(15/50000) = 0.3 \text{ [mrad]}.$$

It is, however, needless to mention that this condition varies depending upon the period T3 of the pattern to be printed and D2 between the second diffraction grating G21 and the surface of the wafer W.

It is also needless to mention that the aforementioned X-direction should be determined according to the relationship with the directions of the periods of the first diffraction grating G11, G 12 and the second diffraction grating G21.

The above described that, on the assumption that the first optically-transparent flat plate P1 and the wafer W were arranged in parallel, the X-directional inclination angle of the specific plane to the direction of the normal to the first optically-transparent flat plate P 1, i.e., the X-directional incidence angle of the illumination light IL8 to the first optically-transparent flat plate P 1 was preferably constant irrespective of locations in the first optically-transparent flat plate P1, but in fact, the X-directional inclination angle of the specific plane or the like is preferably constant or parallel to the direction of the normal to the wafer W.

In order to prevent the position of the interference fringe pattern formed on the wafer W from varying even with some Z-directional variation in the set position of the wafer W, the specific plane is preferably parallel to the direction of the normal to the wafer W; i.e., the specific plane is preferably perpendicular to the wafer W.

Incidentally, for the illumination light IL8 to achieve such strict parallelism, the apparatus is required to have a parallelism fine adjustment mechanism for enabling adjustment of the parallelism. In the exposure apparatus of the present invention, therefore, some lenses of the collimator lens 2, 3, 5, 7 and the illumination-system rear-group lenses 29, 30, 32, 35 are arranged as movable in the traveling direction of the illumination light IL1, IL2, IL7, IL8, as shown in Fig. 1, so as to achieve the foregoing fine adjustment.

The following will describe the parallelism fine adjustment mechanism provided for the illumination-system rear-group lenses 29, 30, 32, 35 in Fig. 1. A lens drive mechanism 31a, 31b is attached to the negative lens 30 of the illumination-system rear-group lenses, and a lens drive mechanism 33a, 33b is attached to the positive lens 32. These lens drive mechanisms 31a, b, 33a, b are movable in the Z-direction on fixed shafts 34a, 34b, whereby the lens 30 and the lens 32 are also movable independently of each other in the Z-direction.

In this configuration the illumination-system rear-group lenses 29, 30, 32, 35 constitute a so-called inner focus lens unit as a whole, and the focal length or focal position thereof is variable. Therefore, the illumination light IL7 from the fly's eye lens 20 can be converted into accurately parallel illumination light IL8, for example, even if the secondary light sources formed on the exit surface of the fly's eye lens 20 are not located at predetermined designed positions because of a manufacturing error or the like.

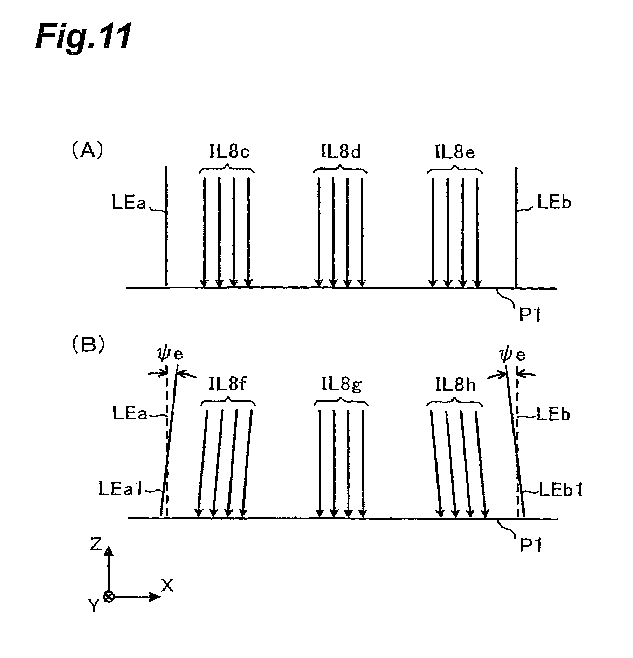

Fig. 11 is a drawing showing that the parallelism of the illumination light IL8 varies with variation in the focal length of the total unit of illumination-system rear-group lenses 29, 30, 32, 35 through drive of the lens 30 and lens 32, and that incidence angles of the illumination light IL8 to the first optically-transparent flat plate P1 vary according to the positions in the first optically-transparent flat plate P1.

Fig. 11 (A) shows a case where the lens 30 and the lens 32 are set at appropriate Z-directional positions, wherein the marginal rays LEa, LEb in the X-direction of the illumination light IL8 are normal to the first optically-transparent flat plate P 1 and wherein illumination light beam IL8c, illumination light beam IL8d, and illumination light beam IL8e are incident normally to the first optically-transparent flat plate P1, irrespective of locations in the first optically-transparent flat plate P1.

On the other hand, Fig. 11 (B) shows a case where the lens 30 and the lens 32 are located with deviation from the appropriate Z-directional positions, wherein the illumination light IL8 defined by the marginal rays LEa1, LEb1 travels in a diverging optical path as a whole. The marginal rays LEa1, LEb1 at this time are inclined (diverging) each at $\varphi e$ from the vertical direction LEa, LEb. Therefore, the incidence angle of the illumination light IL8 to the first optically-transparent flat plate P 1 varies according to locations therein.

Namely, an illumination light beam IL8f applied through an optical path portion near the marginal ray LEa1 is incident to the first optically-transparent flat plate P1 as slightly outwardly inclined. When the angle of inclination is defined as $\psi m$, the position of the light-dark pattern of interference fringes formed on the wafer W with the illumination light beam IL8f comes to have such a positional error that the pattern is formed at a position shifted by an amount approximately proportional to $\psi m$ to the left from the position of the light-dark pattern of the second diffraction grating G21 on the second optically-transparent flat plate P2. The principle thereof is the same as described in Fig. 5.

On the other hand, the position of the light-dark pattern of interference fringes formed on the wafer W with an illumination light beam IL8h applied through an optical path portion near the marginal ray LEb1 is located at a position shifted to the right approximately in proportion to the outward inclination angle $\psi m$ of the illumination light beam IL8h. Furthermore, the position of the light-dark pattern of interference fringes formed on the wafer W with an illumination light beam IL8g applied through an optical path portion near the center has no positional deviation because the illumination light beam IL8h is incident approximately normally.

Therefore, the relation of magnitude of the interference fringe pattern formed on the wafer W, to the light-dark pattern of the second diffraction grating G21 is an enlarged one when the optical path defined by the marginal rays LEa1, LEb1 is a divergent optical path; it is a reduced one when the optical path is a convergent optical path; therefore, a magnification error is produced in either case.

Since in the exposure apparatus of the present invention the lens 30 and lens 32 are set at the appropriate Z-directional positions, the illumination light IL8 defined by the marginal rays LEa, LEb can be always kept as a parallel optical path, so as to prevent occurrence of such a magnification error.

When in the exposure apparatus of the present invention the wafer W to be exposed undergoes unexpected expansion or constriction due to thermal deformation or the like in a prior manufacturing step, the lens 30 and lens 32 are adjusted in position to change the illumination optical path defined by the foregoing marginal rays LEa1, LEb1, to a divergent optical path or to a convergent optical path, whereby the period T3 of interference fringes formed on the wafer W is enlarged or reduced to correct the expansion or constriction of the wafer W, followed by exposure.

The following will describe a parallelism fine adjustment mechanism provided for the collimator lens 2, 3, 5, 7 in Fig. 1. In the collimator lens the negative lens 5 is provided with a lens drive mechanism 6 and the positive lens 7 is provided with a lens drive mechanism 8. These lens drive mechanisms 7, 8 are movable in the X-direction on fixed shafts 9, whereby the lens 5 and lens 7 are also movable independently of each other in the X-direction.

Therefore, this also permits us to adjust the parallelism, convergence degree, and divergence degree of the illumination light IL8 applied onto the first optically-transparent flat plate P1.

The below will describe an optimum value of the distance D2 between the second diffraction grating G21 and the surface of the wafer W. Since the positional deviation of the interference fringe pattern on the wafer W with inclination of the illumination light IL8 is produced in proportion to the distance D2 as described above, the distance D2 is preferably as short as possible if simply considered. The reason is that it can relax the standard for the inclination of the illumination light.

However, if the distance D2 is set too short, a contact can occur between the second diffraction grating G21 and the wafer W, so as to damage them. In order to avoid the contact, the distance D2 should be set to at least the minimum value of 1 $\mu$m, in view of flatness of the wafer W and flatness of the second optically-transparent flat plate P2 in which the second diffraction grating G21 is formed.

In order to securely prevent the foregoing contact, the distance D2 is preferably not less than 5 $\mu$m.

On the other hand, if the distance D2 is set too long, the standard for the inclination of illumination light and the like becomes severer, of course, and the spacing also increases among positions where a plurality of diffracted light beams converged at a point on the wafer W1 leave the second diffraction grating G21, so as to pose a problem of degradation in coherence due to the spatial coherence among these diffracted light beams; therefore, the distance D2 is preferably set to not more than 500 $\mu$m.

As the distance D2 is set shorter, the standard for the inclination of illumination light and the like can be more relaxed and the manufacturing apparatus can be provided at lower cost by that degree; therefore, the distance D2 is more preferably set to not more than 100 $\mu$m.

Since in the present invention the second diffraction grating G21 and the wafer W are arranged in proximity to and opposite to each other, multiple interference of illumination light can occur between the surfaces of the two components. Then this adversely affects the light-dark distribution of interference fringes formed on the wafer W.

In the present invention, therefore, the illumination light IL1-IL8 from the light source 1 is preferably light whose temporal coherence length (coherence length in the traveling direction of light) is not less than about double the distance D2. The temporal coherence length of light is a distance approximately represented by $\lambda^2/\Delta\lambda$, where $\lambda$ is the wavelength of the light and $\Delta\lambda$ a half width of wavelengths in a wavelength distribution of the light.

Therefore, where the exposure wavelength $\lambda$ is 193 nm from the ArF laser, it is desirable to use the illumination light IL1-IL8 with the wavelength half width $\Delta\lambda$ of not less than about 370 pm.

In the case where the interference fringes IF with the one-dimensional period as described above are formed, the illumination light IL8 used for the formation is preferably linearly polarized light the polarization direction (direction of the electric field) of which is the direction parallel to the longitudinal direction of the interference fringes IF (the direction perpendicular to the direction of the period), i.e., the direction perpendicular to the direction of the period. The reason is that the contrast of interference fringes IF becomes maximum in this case.

The illumination light IL8 does not always have to be the perfect linearly polarized light as described above, but may be any illumination light the component of the electric field of which in the longitudinal direction (Y-direction) of the interference fringes IF is greater than the component of the electric field in the direction of the period (X-direction), with the aforementioned contrast enhancing effect.

Since the direction of the period of the interference fringes IF is just coincident with the direction of the period T2 of the second diffraction grating G21, the preferred polarization state of the illumination light IL8 can be, after all, any illumination light the component of the electric field of which in the direction (Y-direction) perpendicular to the direction of the period T2 of the second diffraction grating G21 is greater than the component of the electric field in the direction of the period T2 (X-direction).

Such a polarization characteristic of the illumination light IL8 is realized by the light control element 10 provided in the illumination optical system. The light control element 10 is, for example, a polarization filter (sheet polarizer) or a polarization beam splitter arranged as rotatable around the optical axis AX1 as a rotation-axis direction, and rotation thereof enables the direction of polarization of the illumination light IL3 to be set to predetermined linear polarization.

When the light source 1 is a light source to radiate the illumination light IL 1 polarized approximately as linear polarized light like a laser beam, the light control element 10 to be used can be a half wave plate similarly arranged as rotatable. It is also possible to adopt two quarter wave plates arranged in series and as rotatable independently of each other. In this case, the polarization state of the illumination light IL2-8 can be set not only to approximately linearly polarized light, but also to circularly polarized light and elliptically polarized light.

Incidentally, the distance D1 between the first diffraction grating G11, G12 and the second diffraction grating G21 does not affect the positional deviation or the like of the interference fringes IF formed on the wafer W, at all, and thus the diffraction gratings do not have to be arranged in proximity to each other, different from the case of the distance D2.

However, if the distance D1 is too long, a greater first diffraction grating G11, G12 is needed for applying the $\pm$ first-order diffracted light LP, LM generated from the first diffraction grating G11, G12 to all the necessary portions on the second diffraction grating G21. Therefore, the distance D1 is preferably set, for example, to not more than about 100 mm, in terms of capability of reduction for the size necessary for the first diffraction grating G 11, G12.

On the other hand, if the distance D1 is too small, the $\pm$ first-order diffracted light beams LP, LM generated from the first diffraction grating G11, G12 interfere with each other on the second diffraction grating G21 to form unwanted interference fringes, and they could also finally generate unwanted interference fringes (light-dark unevenness) on the wafer W.

The generation of such unwanted light-dark unevenness can be prevented by applying the $\pm$ first-order diffracted light beams LP, LM generated from an arbitrary point of the first diffraction grating G11, G12, to positions separated from each other sufficiently over the spatial coherence length of the illumination light IL8 on the second diffraction grating G21, e.g., to positions separated by about four times the aforementioned coherence length.

The spatial coherence length of the illumination light IL8 herein is a distance generally represented by $\lambda$/NA, based on the numerical aperture NA and the wavelength $\lambda$ of the illumination light IL8. In a case where the wavelength of the illumination light IL8 is 193 nm and where the numerical aperture NA is the aforementioned 0.3 [mrad] (= 0.0003) being the tolerance for the angular variation of the illumination light IL8 to the specific plane, the coherence length is 643 $\mu$m and four times the coherence length is 2536 $\mu$m. In this case, therefore, the generation of the aforementioned unwanted light-dark unevenness can be prevented by separating the application positions of the $\pm$ first-order diffracted light beams LP, LM onto the second diffraction grating G21 by about 2536 $\mu$m or more.

Where the period T1 of the first diffraction grating G11, G12 is assumed to be 240 nm, the diffraction angle $\theta0$ of the $\pm$ first-order diffracted light LP, LM is determined to be 53° from Formula 1. In order for the two beams generated in symmetry at this diffraction angle, to be applied to the positions 2536 $\mu$m or more separated on the second diffraction grating G21, the distance D1 needs to be not less than 948 $\mu$m.

Therefore, the distance D1 is preferably not less than about 1 mm. The first diffraction grating G11, G 12 is intended for generating the $\pm$ first-order diffracted light beams LP, LM in the predetermined directions and for applying them onto the second diffraction grating G21, but not for forming the interference fringes by the $\pm$ first-order diffracted light beams LP, LM at predetermined positions on the second diffraction grating G21.

Therefore, the positional relation in the XY directions between the first diffraction grating G11, G12 and the second diffraction grating G21 does not always have to be precisely position-adjusted in the order of the periods T1 and T2 (or in the order of several ten nm). However, the $\pm$ first-order diffracted light beams LP, LM generated from the first diffraction grating G11, G12 have to be applied to the predetermined region opposed to the wafer W in the second diffraction grating G21, and therefore the first diffraction grating G11, G12 and the second diffraction grating G21 need to be arranged in alignment, for example, in the positional relation of about several mm in the XY directions.

It is also noted that the direction of the period T1 of the first diffraction grating G11, G12 does not always have to coincide with the direction (X-direction) of the period T2 of the second diffraction grating G21. In this case, however, in order to prevent movement or the like of the light-dark pattern of interference fringes IF with variation in the Z-directional position of the wafer W, a projected length of the period T1 of the first diffraction grating G11, G12 into the ZX plane, preferably satisfies the condition of Formula 4, instead of the period T1.

Incidentally, the exposure apparatus of the present invention uses the illumination light with the extremely small illumination NA in the X-direction as described above, but the illumination light (diffracted light) arriving at a point on the wafer W is composed of a plurality of illumination light beams; therefore, the wafer is illuminated from a plurality of regions on the second diffraction grating G21 and the first diffraction grating G11, G12. Since a beam of light rays forming the interference fringes on the wafer W is entirely the diffracted light from the second diffraction grating and others, even if there is foreign matter or the like on the second diffraction grating G21 or the like, the foreign matter is not transferred in its original shape onto the wafer W.

In order to further reduce the adverse effect of the foreign matter and defect on the second diffraction grating G21, G22 on the interference fringes formed on the wafer W, the distance D2 to the second diffraction grating G21, G22 is preferably set to not less than a predetermined value. The reason is that it allows the light applied onto a point on the wafer W, to consist of light diffracted from more locations on the second diffraction grating G21, G22, and thus can relax the adverse effect of the foreign matter and defect.

Here the diffracted light applied from the second diffraction grating G21 onto the wafer W is applied at the angles $\theta0$ and $\theta1$ of inclination to the wafer W as described above. In the more preferred condition $\theta0 = \theta1$. At this time, where $\lambda$ is the effective wavelength of the illumination light and T2 is the period of the second diffraction grating G21, (Formula 8) $\sin\theta0 = \lambda/(2 \times T2)$ is derived from Formula 2 and Formula 3, and, on the assumption that the approximation of sinθ0 ≒ tanθ0 holds to some extent, the diffracted light applied to a point on the wafer W is applied from portions centered on two points separated by a mutual distance D5 represented by (Formula 9) below, on the second diffraction grating G21:

$$\text{(Formula 9)}$$

$$D5 = 2 \times D2 \times \lambda / (2 \times T2).$$

In order to relax the adverse effect of the foreign matter and defect, the light converged at a point on the wafer W is preferably, for example, light from portions spreading over about 30 times the period T2 of the second diffraction grating G21 so as to smooth the adverse effect. This can be expressed by the following Formula 10:

$$\text{(Formula 10)}$$

$$D5 \geq 30 \times T2.$$

From the aforementioned Formula 9 and Formula 10, the distance D2 preferably satisfies the following condition of Formula 11:

$$\text{(Formula 11)}$$

$$D2 \geq 30 \times T2^2 / \lambda.$$

In order to further relax the above adverse effect, the light converged at a point on the wafer W is preferably composed, for example, of light from portions spreading over about 100 times the period T2 of the second diffraction grating G21 so as to smooth the adverse effect. At this time the condition for the distance D2 to satisfy, is given by Formula 12 below from the same consideration:

$$\text{(Formula 12)}$$

$$D2 \geq 100 \times T2^2 / \lambda.$$

In order to further reduce the adverse effect of the foreign matter and defect on the second diffraction grating G21 on the pattern for the exposure on the wafer W, the exposure on the wafer W in the present invention can also be multiple exposure consisting of a plurality of exposure operations as described below.

Specifically, the first exposure operation is carried out by setting the positional relation in the XY directions between the second diffraction grating G21 and the wafer W in a predetermined relation, the relative relation is then moved by a multiple integral of the period of the second diffraction grating G21, or by an arbitrary distance in the direction perpendicular of the period direction of the second diffraction grating G21, the second exposure operation is then carried out, and multiple exposure is carried out through multiple operations with similar movement.

This leads to superposed exposure of light-dark patterns of interference fringes by diffracted light generated from more portions on the second diffraction grating G21, at a point on the wafer W, whereby the adverse effect of the foreign matter and defect present on the second diffraction grating G21 can be further reduced by averaging effect.

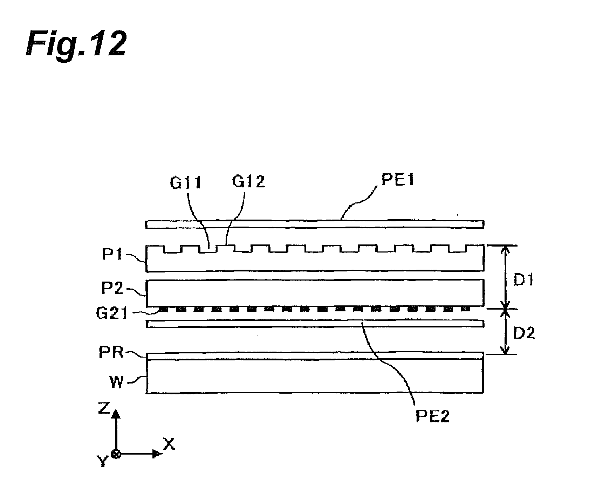

Incidentally, in order to further reduce the adverse effect of the foreign matter and the like adhering onto the second diffraction grating G21, it is also possible to locate a thin film (pellicle) PE2 for prevention of adhesion of foreign matter to the second diffraction grating G21, between the second diffraction grating G21 and the wafer W, as shown in Fig. 12. The pellicle PE2 is replaced, for example, every exposure of a predetermined number of wafers W, thereby eliminating the foreign matter.

The pellicle PE2 to be used can be, for example, a pellicle of organic resin used for prevention of adhesion of foreign matter to a reticle as used in the projection exposure apparatus.

Another example of the pellicle PE2 applicable is an optically-transparent flat plate made of an inorganic material such as synthetic silica.

A pellicle PE1 may also be provided on the light source side of the first diffraction grating G11, G12, whereby the foreign matter can be prevented from adhering to the first diffraction grating G 11, G12.

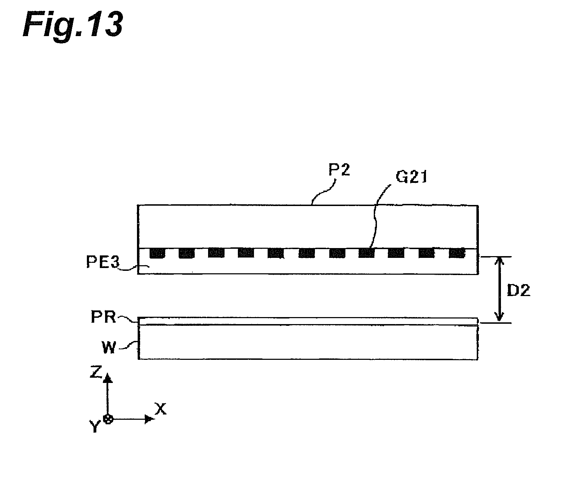

In another example, in order to prevent the adhesion of foreign matter onto the second diffraction grating G21, a protecting layer PE3 can be located on the second diffraction grating G21 on the second optically-transparent substrate P2, as shown in Fig. 13. This protecting layer PE3 is comprised, for example, of an optically-transparent film of silicon dioxide or the like formed by CVD (Chemical Vapor Deposition), the surface of which is planarized, if necessary, by CMP (Chemical Mechanical Polishing). The thickness of the foreign matter protecting layer PE3 is, for example, about 1 $\mu$m.

The foreign matter adhering on the protecting layer PE3 and the foreign matter adhering on the second diffraction grating G21 without provision of the protecting layer PE3 are equivalent in terms of the adverse effect of the foreign matter on the interference fringes to be formed on the wafer. However, the provision of the protecting layer PE3 can substantially planarize the surface of the second diffraction grating G21, and therefore the placement of the protecting layer PE3 is effective in that it is very easy to perform cleaning and inspection for the foreign matter, contamination, etc. adhering on the surface.

The above example showed the configuration wherein the first diffraction grating G11, G12 was the phase modulation type diffraction grating and the second diffraction grating G21 the intensity modulation type diffraction grating, but configurations of the two diffraction gratings are not limited to it.

For example, either or both of the two diffraction gratings can be diffraction gratings for modulating both the phase and intensity of transmitted light, like halftone phase shift reticles (Attenuated Phase Shift Masks). When the contrast required is not so high for the interference fringes formed on the wafer W, the first diffraction grating can also be an intensity modulation type diffraction grating because the first diffraction grating is permitted to generate unwanted diffracted light.

The above example showed the configuration wherein the first diffraction grating G11, G12 and the second diffraction grating G21 were formed on their respective separate optically-transparent flat plates, but the two diffraction gratings can also be formed on a single optically-transparent flat plate.

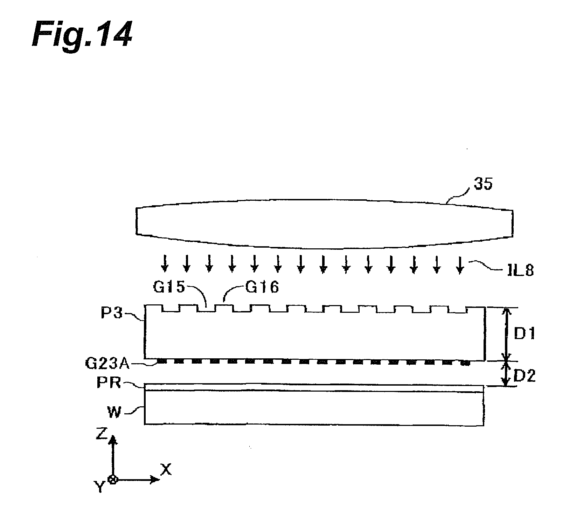

Fig. 14 is a drawing showing an example in which the first diffraction grating G15, G16 and the second diffraction grating G23 are formed on the light source side and on the wafer W side, respectively, of a single optically-transparent flat plate P3. In this example, the structure and production process of each diffraction grating are much the same as in the aforementioned example. The lens 35 and the illumination optical system upstream thereof are also similar to those in the foregoing example.

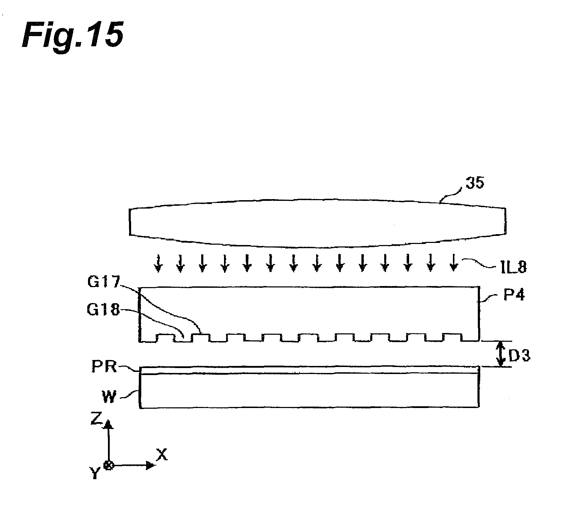

In an embodiment of the present invention, only one diffraction grating is arranged in proximity and opposite to the wafer W, whereby a light-dark pattern of interference fringes can also be formed on the wafer W. Fig. 15 is an example in which a diffraction grating G17, G18 formed on the wafer W side of an optically-transparent flat plate P4 is arranged in proximity and opposite to the wafer W with a distance D3 near the wafer W. In the present example, the structure and production process of the diffraction grating G17, G18 are similar to those in the foregoing example. The lens 35 and the upstream illumination optical system are also similar to those in the aforementioned example. Furthermore, the value of the distance D3 also preferably satisfies the same condition as that for the distance D2 in the foregoing example.

In the present example, the effective wavelength $\lambda$ refers to the wavelength of the illumination light in the medium with the minimum refractive index, among the optically-transparent media existing on the illumination optical path from the diffraction grating G17, G18 to the wafer W.

In the present example, diffracted light beams (first-order diffracted light) generated in the diffraction grating G17, G18 are applied onto the wafer W and interfere with each other on the wafer W to form a light-dark pattern of interference fringes on the wafer W.

Incidentally, when the first diffraction grating G11, G12 in the configuration shown in Fig. 3, the first diffraction grating G15, G16 in the configuration shown in Fig. 14, or the diffraction grating G17, G18 in the configuration shown in Fig. 15 is composed of an intensity modulation type diffraction grating, or a halftone type diffraction grating, the zero-order light (straight traveling light) is also generated from those diffraction gratings. This zero-order light is applied, basically as unwanted illumination light, through the second diffraction grating G21, G23 or directly onto the wafer W to degrade the desired original contrast of interference fringes.

Even with these intensity modulation type or halftone type diffraction gratings, however, when the illumination light IL8 is made incident at a predetermined angle of inclination, the angular distribution of diffracted light generated therefrom can be made substantially equivalent to the angular distribution of diffracted light in the case of normal incidence to the phase modulation type diffraction grating of the period T1 described above.

Specifically, where the diffraction grating used is an intensity modulation type or halftone type diffraction grating having the period T5 in the X-direction as defined by Formula 13 below:

## (Formula 13)

$$T5 = T1/2,$$

d where the illumination light IL8 is made incident as inclined at θ0 determined from Formula 1, in the X-direction, the zero-order light thereof is generated at θ0 of inclination in the X-direction corresponding to the angle of incidence, and one of the first-order light is generated at θ0 of inclination on the opposite side in the X-direction. The diffraction angles of these zero-order light and first-order light in the X-direction are substantially equivalent to the diffraction angle distribution of the ± first-order diffracted light beams LP, LM in the case of normal incidence to the phase modulation type diffraction grating G11, G12 shown in Fig. 3.

Such illumination light can be realized by locating the fly's eye lens 20 shown in Fig. 7 (B), with a shift of a predetermined amount in the X-direction. In this case, it is needless to mention that it is desirable to shift all the optical systems upstream of the fly's eye lens 20 by the same predetermined amount in the X-direction.

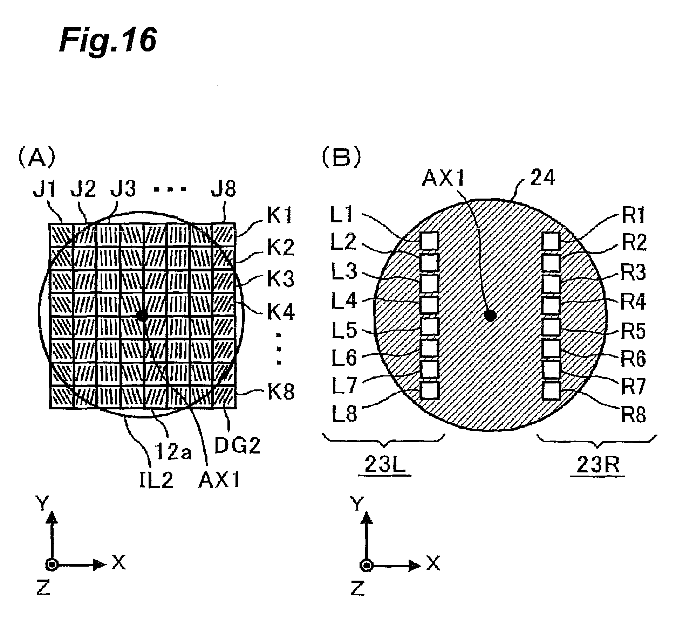

It is also possible to use two fly's eye lenses 23L, 23R arranged as shifted in the negative direction and the positive direction of the X-direction with respect to the optical axis AX1, as shown in Fig. 16 (B). In this case, each of the fly's eye lenses 23L, 23R, similar to the fly's eye lens shown in Fig. 7 (B), is composed of lens elements L1, L2, L3, L4, L5, L6, L7, L8; R1, R2, R3, R4, R5, R6, R7, R8 arranged along the Y-direction on a light-shielding member 24.

An input fly's eye lens 12a, as shown in Fig. 16 (A), is preferably used in order to converge the illumination light on these fly's eye lenses 23L, 23R. This is a lens having a configuration approximately similar to the fly's eye lens 12 shown in Fig. 7 (A), but is characterized in that a diffraction grating DG2 formed on the exit surface of each element has a fixed value of the period in the X-direction and has the period in the Y-direction varying according to the array position J1-J8 in the X-direction.

Namely, the direction of the period determined by combination of the X-directional and Y-directional periods varies depending upon the X-directional array position J1-J8.

Furthermore, the diffracted light generated from each diffraction grating DG2 is substantially two diffracted light beams consisting of ± first-order diffracted light beams. It is a matter of course that this can be realized by a phase type diffraction grating of a simple structure.

For example, among diffracted light beams from the respective lens elements arranged on the X-directional array position J2, the + first-order diffracted light beams are superposed and applied onto the lens element L3 of the fly's eye lens 23L, and the - first-order diffracted light beams are superposed and applied on the lens element R6 of the fly's eye lens 23R located at the position symmetric to the lens element L3 with respect to the optical axis AX1.

Concerning diffracted light beams from the respective lens elements arranged on the other array positions in the X-direction, the ± first-order diffracted light beams thereof are also superposed and applied on the lens elements arranged in symmetry with respect to the optical axis AX1.

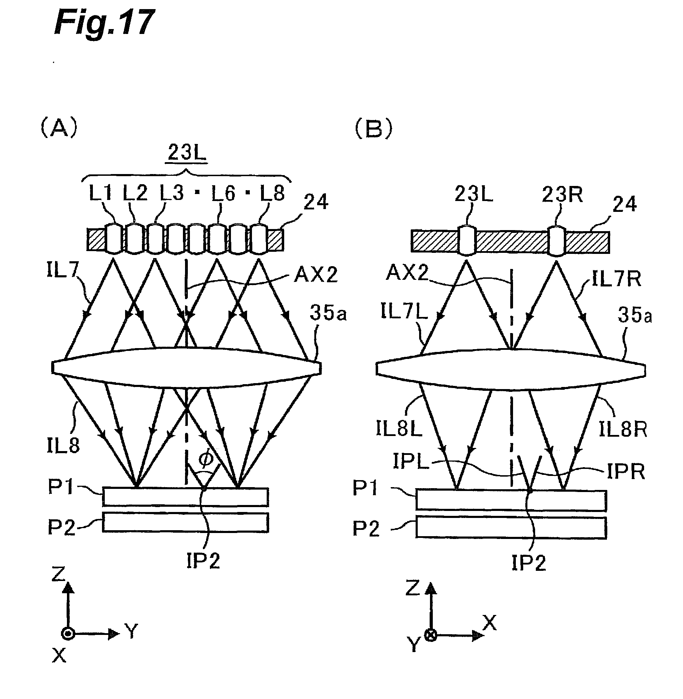

In this manner, illumination light beams IL7L, IL7R emitted from the fly's eye lenses 23L and 23R are applied onto the first optically-transparent parallel plate P1 as shown in Fig. 17 (A) and Fig. 17 (B).

Namely, as to the illumination light IL8 applied onto an arbitrary point IP2 on the first optically-transparent parallel plate P1, the incidence angle range thereof in the Y-direction is similar to the angle range φ shown in Fig. 7 (A), but the incidence angles thereof in the X-direction are those of the illumination light IL8L having traveling directions in the plane of the first specific plane IPL and the illumination light IL8R having traveling directions in the plane of the second specific plane IPR, which are applied onto the first optically-transparent parallel plate P1.

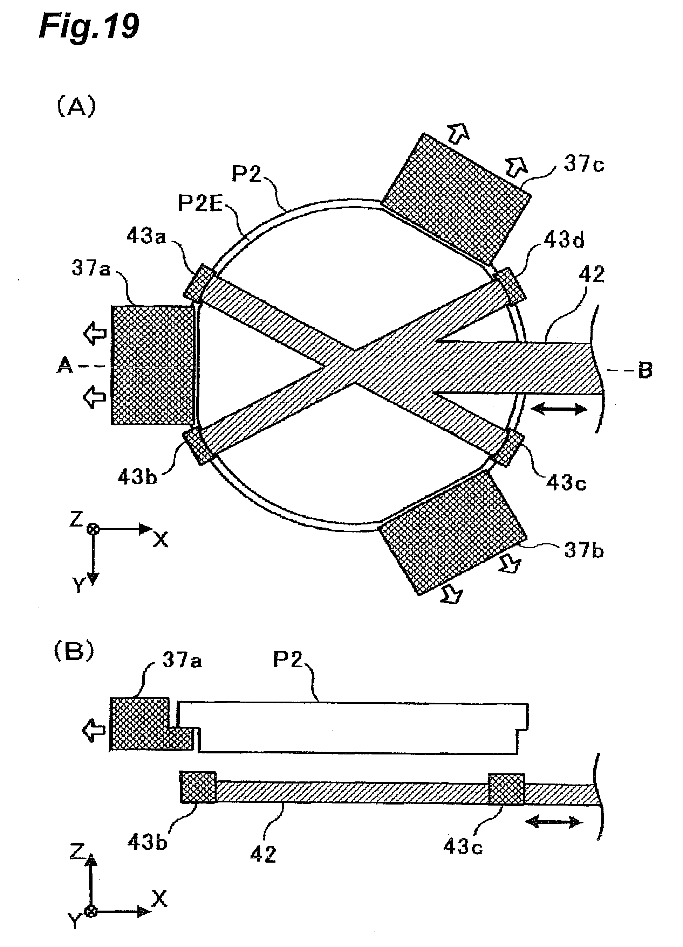

In any one of the above-described examples, the first diffraction grating G11, G12 and the second diffraction grating G21 need to be replaced according to the period T3 of the light-dark pattern of interference fringes to be formed on the wafer W. Fig. 19 is a drawing showing an example of a replacing mechanism for the gratings, wherein Fig. 19 (A) is a view of the mechanism from the - Z-direction and Fig. 19 (B) a sectional view near portion A-B in Fig. 19 (A).

A plate loader 42 is provided with chuck portions 43a, 43b, 43c, 43d for holding the peripheral portion P2E of the second optically-transparent parallel plate P2 on which the second diffraction grating is placed, by such means as vacuum suction, and the plate loader 42 is slidable in the X-direction and vertically movable in the Z-direction.

Before the replacement, the second optically-transparent parallel plate P2 is held by a second holding mechanism 37a, 37b, 37c. In this state, the plate loader 42 is moved in the X-direction to below the second optically-transparent parallel plate P2 and then moved upward. Then the chuck portions 43a, 43b, 43c, 43d suck and hold the peripheral portion P2E of the second optically-transparent parallel plate P2.

Thereafter, the second holding mechanism 37a, 37b, 37c is radially retracted as indicated by outline arrows in the drawing, and in that state the plate loader 42 is retracted in the + X-direction to carry the second optically-transparent parallel plate P2 away. Then another second optically-transparent parallel plate to be newly loaded is set on the second holding mechanism 37a, 37b, 37c through an operation reverse to the above operation, thereby completing the replacement of the second optically-transparent parallel plate.

A replacement mechanism for the first optically-transparent parallel plate P1 also has a configuration similar to the above.

Since the space is small between the first optically-transparent parallel plate P1 and the second optically-transparent parallel plate P2, it is difficult to put the plate loader into the space.

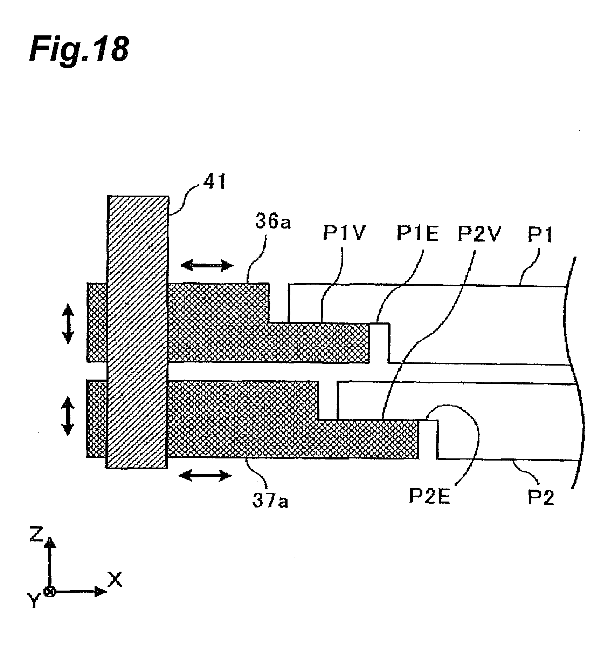

It is thus preferable to adopt a configuration, as shown in Fig. 18, wherein the first holding mechanism 36a and others and the second holding mechanism 37a and others both are supported by a support member 41 so as to be movable in the radial directions as directions in the XY planes and in the Z-directions. This allows the apparatus to ensure a clearance for loading of the plate loader.

The above-described Z-drive mechanism for the first holding mechanism 36a and others and the second holding mechanism 37a and others can also be used on the occasion of setting the distance D2 between the second diffraction grating G21 and the wafer W and the distance D1 between the first diffraction grating G11, G12 and the second diffraction grating G21 to predetermined values.

As shown in Fig. 18, the peripheral portion P1E of the first optically-transparent parallel plate P 1 and the peripheral portion P2E of the second optically-transparent parallel plate P2 are so stepped as to be smaller than the central portions thereof. A vacuum suction part P1V provided in the first holding mechanism 36a and others and a vacuum suction part P2V provided in the second holding mechanism 37a and others are arranged to hold the first optically-transparent parallel plate P1 and the second optically-transparent parallel plate P2 through these stepped peripheral portions P1E and PE2.

Incidentally, in the above examples air (or nitrogen or rare gas) was present between the second diffraction grating G21 and the wafer W, but a predetermined dielectric may replace it to fill the space. This can reduce the substantial wavelength of illumination light (diffracted light) applied onto the wafer W, by the degree of the refractive index of the dielectric, whereby the period T3 of the light-dark pattern of interference fringes formed on the wafer W can be further reduced. It is needless to mention that, for implementing it, the period T2 of the second diffraction grating G21 and the period T1 of the first diffraction grating G11, G 12 need to be decreased in proportion thereto.

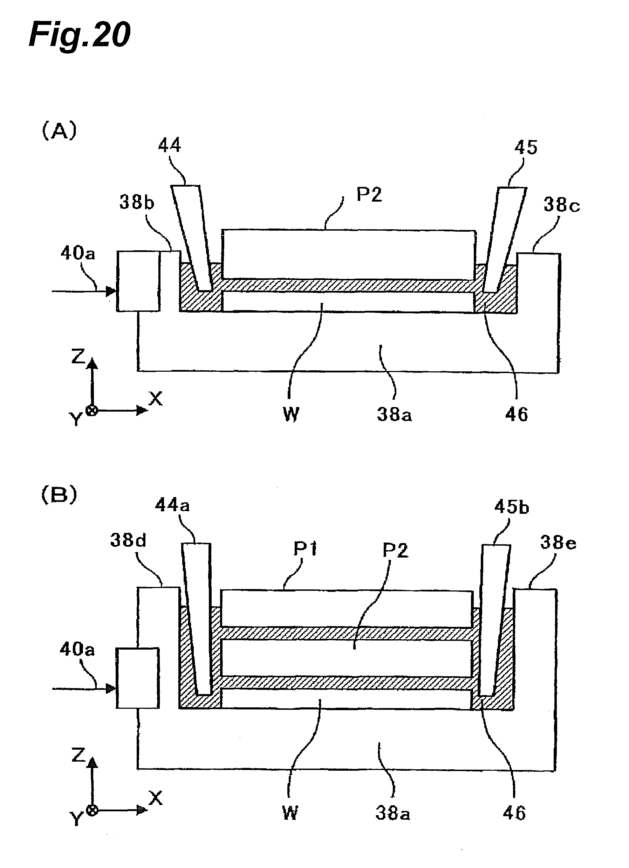

Fig. 20 (A) is a drawing showing an example of a wafer stage 38a and others suitable for it. A continuous side wall 38b, 38c is provided around the wafer stage 38a, so that a liquid 46 such as water can be reserved in a space surrounded by the side wall 38b, c. By this configuration, the space between the wafer W and the second optically-transparent flat plate P2 is filled with water, i.e., the space between the wafer W and the second diffraction grating G21 is filled with water being a dielectric, whereby the wavelength of the illumination light is decreased by the refractive index of water (1.46 for light of the wavelength 193 nm).

A water supply mechanism 44 and a water discharge mechanism 45 are also provided, so that fresh water without contamination can be supplied into and discharged from the space surrounded by the side wall 38b, c.

It is also possible to adopt a configuration, as shown in Fig. 20 (B), wherein the top surface of the side wall 38d, 38e of the wafer stage 38a is set higher than the bottom surface of the first optically-transparent flat plate P 1 and wherein the space between the first optically-transparent flat plate P 1 and the second optically-transparent flat plate P2 is also filled with water. The functions of water supply mechanism 44a and the water discharge mechanism 45b are similar to those described above.

This permits the entire optical path from the first diffraction grating G11, G12 to the wafer W to be covered with the dielectric (water) except for air (or nitrogen or rare gas), whereby the effective wavelength $\lambda$ of the illumination light can be decreased by the degree of refraction of water. This enables exposure of a pattern with a finer period.

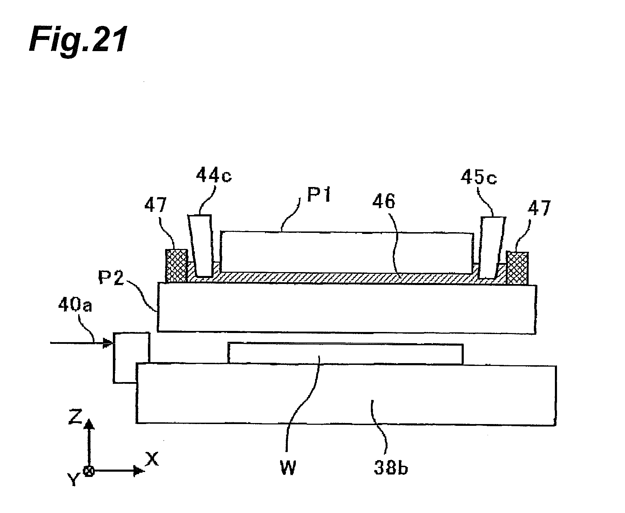

When it is effective to fill only the space between the first optically-transparent flat plate P1 and the second optically-transparent flat plate P2 with the dielectric such as water, it is also possible to adopt a configuration as shown in Fig. 21.

This is the configuration wherein a continuous side wall 47 is provided around the first optically-transparent flat plate P1 whereby water is reserved between the first optically-transparent flat plate P1 and the second optically-transparent flat plate P2. The functions of water supply mechanism 44c and water discharge mechanism 45c are similar to those described above.

The refractive index of the dielectric to fill the optical path from the first diffraction grating G11, G12 to the wafer W, or the space between the first optically-transparent flat plate P1 and the second optically-transparent flat plate P2 is preferably not less than 1.2. If this refractive index is below 1.2, it is infeasible to achieve a satisfactory improvement in the degree of fineness of the pattern available for exposure.

The wafer W after the exposure of the light-dark pattern of the interference fringes as described above is carried out of the exposure apparatus by an unrepresented wafer loader and carried to a developing apparatus. The development results in forming a resist pattern according to the printed light-dark pattern in the photoresist on the wafer W. Then an etching system is used to etch the wafer W or a predetermined film formed on the wafer W, using the resist pattern as an etching mask, to form a predetermined pattern in the wafer W.

Steps of manufacturing electronic devices such as semiconductor integrated circuits, flat panel displays, thin-film magnetic heads, and micro machines include steps of forming a fine pattern as described above, in a large number of layers. The above-described exposure method by the exposure apparatus of the present invention can be used in at least one step among the steps of forming the large number of patterns, to manufacture the electronic devices.

In the at least one step, combined exposure with a pattern of a predetermined shape made with an ordinary projection exposure apparatus can be effected on a photoresist PR on the wafer W after the exposure of the light-dark pattern of interference fringes by the above-described exposure method by the exposure apparatus of the present invention, and the photoresist PR after the combined exposure is then developed, to form the above pattern. Conversely, combined exposure with a light-dark pattern of interference fringes by the exposure method by the exposure apparatus of the present invention can be effected for a photoresist PR on the wafer W after exposure of the pattern of the predetermined shape made with an ordinary projection exposure apparatus, and the photoresist PR after the combined exposure is then developed, to form the above pattern.

The present invention, without having to be limited to the above-described embodiments, can be modified in various ways without departing from the scope and spirit of the present invention. The entire disclosure in Japanese Patent Application No. 2005-007125 filed on January 14, 2005, including the specification, scope of claims, drawings, and abstract, is incorporated herein by reference in its entirety.

Industrial Applicability

The exposure method of the present invention can be carried out in the manufacture of the electronic devices such as the semiconductor integrated circuits, flat panel displays, thin-film magnetic heads, and micro machines, and is thus industrially applicable.

The exposure apparatus of the present invention can be carried out in the manufacture of the electronic devices such as the semiconductor integrated circuits, flat panel displays, thin-film magnetic heads, and micro machines, and is thus industrially applicable.

The electronic device manufacturing method and the electronic devices of the present invention are applicable in the industries in the manufacturing process, i.e., in industries of producing semiconductors, and the electronic devices as products are applicable in various electronic equipment industries.

**Claims**

1. An exposure method of effecting exposure of a pattern on a photosensitive substrate with illumination light from a light source, the exposure method comprising:

   a step of applying the illumination light from the light source onto a first diffraction grating;
   a step of applying diffracted light generated by the first diffraction grating, onto a second diffraction grating arranged opposite to the first diffraction grating; and
   a step of applying diffracted light generated by the second diffraction grating, onto the photosensitive substrate arranged opposite to and in proximity to the second diffraction grating;

   wherein a major portion of the illumination light applied onto an arbitrary point of the first diffraction grating comprises a plurality of illumination light beams having respective traveling directions in at least one specific plane including a longitudinal direction perpendicular to a direction of a period of the second diffraction grating, and including said point, and said traveling directions are not parallel to each other.

2. The exposure method according to claim 1, wherein an intensity distribution of the illumination light applied onto the first diffraction grating is substantially uniform in a predetermined region including a central portion of the first diffraction grating.

3. The exposure method according to claim 1, wherein at least either the first diffraction grating or the second diffraction grating is a diffraction grating having a period of not more than three times an effective wavelength of the illumination light.

4. The exposure method according to claim 1, wherein at least either the first diffraction grating or the second diffraction grating is a phase modulation type diffraction grating to modulate a phase of transmitted light.

5. The exposure method according to claim 1, wherein at least either the first diffraction grating or the second diffraction grating is an intensity modulation type diffraction grating to modulate an intensity of transmitted light.

6. The exposure method according to claim 1, wherein a period in a first predetermined direction of the first diffraction grating is substantially twice the period in the first predetermined direction of the second diffraction grating.

7. The exposure method according to claim 1, wherein a period in a first predetermined direction of the first diffraction grating is substantially equal to the period in the first predetermined direction of the second diffraction grating.

8. The exposure method according to claim 1, wherein the specific plane is one plane substantially perpendicular to the substrate.

9. The exposure method according to claim 8, wherein an angular relation of the specific plane to the substrate varies according to a position of said point in the direction of the period of the second diffraction grating.

10. The exposure method according to claim 1, wherein the specific plane is one plane inclined at a predetermined angle of inclination relative to a direction of a normal to the substrate.

11. The exposure method according to claim 1, wherein the specific plane is two planes inclined substantially in symmetry at a predetermined angle of inclination relative to a direction of a normal to the substrate.

12. The exposure method according to claim 11, wherein the predetermined angle $\theta$ of the inclination of the specific plane substantially satisfies a relation of $n \times \sin\theta = \lambda / (2 \times T)$ where $\lambda$ is a wavelength of the illumination light, n is a refractive index of a medium on the light source side of the first diffraction grating for the illumination light, and T is a period of the first diffraction grating.

13. The exposure method according to claim 1, wherein said illumination light applied onto the first diffraction grating is illumination light a component of an electric field of which in the direction perpendicular to the direction of the period of the second diffraction grating is greater than a component of the electric field in the direction of the period of the second diffraction grating.

14. The exposure method according to claim 1, wherein while a relative positional relation in in-plane directions of the substrate between the second diffraction grating and the substrate is shifted in the direction perpendicular to the direction of the period of the second diffraction grating, or shifted in the direction of the period by a length equal to an integral multiple of the period of the second diffraction grating, said steps are repeatedly carried out plural times.

15. The exposure method according to claim 1, wherein a distance between the second diffraction grating and the substrate is between 1 $\mu$m and 500 $\mu$m.

16. The exposure method according to claim 1, wherein a distance between the second diffraction grating and the substrate is between 5 $\mu$m and 100 $\mu$m.

17. The exposure method according to claim 1, wherein a distance D between the second diffraction grating and the substrate satisfies the following relation:

$$30 \times T^2 / \lambda \leq D,$$

where $\lambda$ is an effective wavelength of the illumination light and T is a minimum period of the second diffraction grating.

18. The exposure method according to claim 1, wherein a distance D between the second diffraction grating and the substrate satisfies the following relation:

$$100 \times T^2 / \lambda \leq D,$$

where $\lambda$, is an effective wavelength of the illumination light and T is a minimum period of the second diffraction grating.

19. The exposure method according to claim 1, wherein at least either a space between the second diffraction grating and the substrate or a space between the first diffraction grating and the second diffraction grating is filled with a dielectric having a refractive index of not less than 1.2 at a wavelength of the exposure.

20. The exposure method according to claim 19, wherein a portion of the dielectric is water.

21. The exposure method according to claim 1, wherein the first diffraction grating is formed on a surface on the light source side of a first optically-transparent flat plate, or near the surface on the light source side in the first optically-transparent flat plate.

22. The exposure method according to claim 1, wherein the second diffraction grating is formed on a surface on the substrate side of a second optically-transparent flat plate, or near the surface on the substrate side in the second optically-transparent flat plate.

23. The exposure method according to claim 21, wherein the second diffraction grating is formed on a surface on the substrate side of the first optically-transparent flat plate or near the surface on the light source side in the first optically-transparent flat plate.

24. The exposure method according to claim 1, wherein an optically-transparent flat plate or thin film is provided at least either on the light source side of the first diffraction grating or on the substrate side of the second diffraction grating.

25. The exposure method according to claim 1, wherein a temporal coherence length of the illumination light is not more than 100 $\mu$m.

26. An exposure method of effecting exposure of a pattern on a photosensitive substrate with illumination light from a light source, the exposure method comprising:

   a step of applying the illumination light from the light source onto a diffraction grating; and
   a step of applying diffracted light generated by the diffraction grating, onto the photosensitive substrate arranged opposite to and in proximity to the diffraction grating;

   wherein a major portion of the illumination light applied onto an arbitrary point of the diffraction grating comprises a plurality of illumination light beams having respective traveling directions in at least one specific plane including a longitudinal direction perpendicular to a direction of a period of the diffraction grating, and including said point, and said traveling directions are not parallel to each other.

27. The exposure method according to claim 26, wherein an intensity distribution of the illumination light applied onto the diffraction grating is substantially uniform in a predetermined region including a central portion of the diffraction grating.

28. The exposure method according to claim 26, wherein the diffraction grating is a diffraction grating having a period of not more than three times an effective wavelength of the illumination light.

29. The exposure method according to claim 26, wherein the diffraction grating is a phase modulation type diffraction grating to modulate a phase of transmitted light.

30. The exposure method according to claim 26, wherein the diffraction grating is an intensity modulation type diffraction grating to modulate an intensity of transmitted light.

31. The exposure method according to claim 26, wherein the specific plane is one plane substantially perpendicular to the substrate.

32. The exposure method according to claim 31, wherein an angular relation of the specific plane to the substrate varies according to a position of said point in the direction of the period of the diffraction grating.

33. The exposure method according to claim 26, wherein the specific plane is one plane inclined at a predetermined angle of inclination relative to a direction of a normal to the substrate.

34. The exposure method according to claim 26, wherein the specific plane is two planes inclined substantially in symmetry at a predetermined angle of inclination relative to a direction of a normal to the substrate.

35. The exposure method according to claim 34, wherein the predetermined angle θ of the inclination of the specific plane substantially satisfies a relation of $n \times \sin\theta = \lambda / (2 \times T)$ where λ is a wavelength of the illumination light, n is a refractive index of a medium on the light source side of the diffraction grating for the illumination light, and T is the period of the diffraction grating.

36. The exposure method according to claim 26, wherein said illumination light applied onto the diffraction grating is illumination light a component of an electric field of which in the direction perpendicular to the direction of the period of the diffraction grating is greater than a component of the electric field in the direction of the period of the diffraction grating.

37. The exposure method according to claim 26, wherein while a relative positional relation in in-plane directions of the substrate between the diffraction grating and the substrate is shifted in the direction perpendicular to the direction of the period of the diffraction grating, or shifted in the direction of the period by a length equal to an integral multiple of the period of the diffraction grating, said steps are repeatedly carried out plural times.

38. The exposure method according to claim 26, wherein a distance between the diffraction grating and the substrate is between 1 μm and 500 μm.

39. The exposure method according to claim 26, wherein a distance between the diffraction grating and the substrate is between 5 μm and 100 μm.

40. The exposure method according to claim 26, wherein a distance D between the diffraction grating and the substrate satisfies the following relation:

$$30 \times T^2 / \lambda \leq D,$$

where λ is an effective wavelength of the illumination light and T is a minimum period of the diffraction grating.

41. The exposure method according to claim 26, wherein a distance D between the diffraction grating and the substrate satisfies the following relation:

$$100 \times T^2 / \lambda \leq D,$$

where λ is an effective wavelength of the illumination light and T is a minimum period of the diffraction grating.

42. The exposure method according to claim 26, wherein a space between the diffraction grating and the substrate is filled with a dielectric having a refractive index of not less than 1.2 at a wavelength of the exposure.

43. The exposure method according to claim 42, wherein a portion of the dielectric is water.

44. The exposure method according to claim 26, wherein the diffraction grating is formed on a surface on the substrate side of an optically-transparent flat plate, or near the surface on the substrate side in the optically-transparent flat plate.

45. The exposure method according to claim 26, wherein an optically-transparent flat plate or thin film is provided on the substrate side of the diffraction grating.

46. The exposure method according to claim 26, wherein a temporal coherence length of the illumination light is not more than 100 μm.

47. An electronic device manufacturing method wherein the exposure method as defined in any one of claims 1 to 46 is used in at least one of steps of forming a circuit pattern for making up an electronic device.

**48.** An electronic device manufacturing method wherein combined exposure of a projection exposure method using a projection exposure apparatus, and the exposure method as defined in any one of claims 1 to 46 is used in at least one of steps of forming a circuit pattern for making up an electronic device.

**49.** An exposure apparatus for effecting exposure on a photosensitive substrate, of an interference pattern generated by a first diffraction grating formed in a first optically-transparent flat plate and a second diffraction grating formed in a second optically-transparent flat plate, with illumination light from a light source, said exposure apparatus comprising:

a first holding mechanism which holds the first diffraction grating formed in the first optically-transparent flat plate, at a predetermined position;
a second holding mechanism which holds the second diffraction grating formed in the second optically-transparent flat plate, in alignment at a position opposite to the first diffraction grating;
a substrate holding mechanism which holds the substrate in alignment at a position opposite to and in proximity to the second diffraction grating; and
an illumination optical system which applies the illumination light from the light source onto the first diffraction grating, wherein a major portion of the illumination light applied onto an arbitrary point of the first diffraction grating comprises a plurality of illumination light beams having respective traveling directions in at least one specific plane including a Y-direction, which is a specific direction in a plane on which the substrate is placed, and including said point, and the traveling directions are not parallel to each other.

**50.** The exposure apparatus according to claim 49, wherein the second optically-transparent flat plate is held so that a direction of a period of the second diffraction grating is substantially perpendicular to the Y-direction.

**51.** The exposure apparatus according to claim 49, wherein the first optically-transparent flat plate is held so that a direction of a period of the first diffraction grating is substantially perpendicular to the Y-direction.

**52.** The exposure apparatus according to claim 49, comprising at least either a first replacing mechanism which replaces the first optically-transparent flat plate, or a second replacing mechanism which replaces the second optically-transparent flat plate.

**53.** The exposure apparatus according to claim 49, wherein the illumination optical system comprises illumination light uniformizing means which substantially uniformizes an intensity distribution of the illumination light in a plane where the first diffraction grating is placed.

**54.** The exposure apparatus according to claim 53, wherein the illumination light uniformizing means includes at least one fly's eye lens in which lens elements are arrayed along the Y-direction.

**55.** The exposure apparatus according to claim 54, wherein the illumination light uniformizing means comprises a condensing optical system which substantially limits illumination light incident to an arbitrary lens element in said at least one fly's eye lens, to illumination light distributed in a predetermined range in an X-direction perpendicular to the Y-direction, among illumination light distributed in a predetermined plane on the light source side with respect to the fly's eye lens in the illumination light uniformizing means.

**56.** The exposure apparatus according to claim 54, wherein the illumination light uniformizing means comprises secondary illuminant position correcting means which arrays a plurality of secondary light sources formed on an exit surface of said at least one fly's eye lens, substantially on a line parallel to the Y-direction.

**57.** The exposure apparatus according to claim 49, wherein the specific plane is one plane substantially perpendicular to the plane on which the substrate is placed.

**58.** The exposure apparatus according to claim 57, wherein an angular relation of the specific plane to the plane on which the substrate is placed varies according to a position of said point in an X-direction perpendicular to the Y-direction.

**59.** The exposure apparatus according to claim 49, wherein the specific plane is one plane inclined at a predetermined angle of inclination relative to a direction of a normal to the plane on which the substrate is placed.

60. The exposure apparatus according to claim 49, wherein the specific plane is two planes inclined substantially in symmetry at a predetermined angle of inclination relative to a direction of a normal to the plane on which the substrate is placed.

61. The exposure apparatus according to claim 60, wherein the predetermined angle θ of the inclination of the specific plane substantially satisfies a relation of $n \times \sin\theta = \lambda / (2 \times T)$ where λ is a wavelength of the illumination light, n is a refractive index of a medium on the light source side of the first diffraction grating for the illumination light, and T is a period of the first diffraction grating.

62. The exposure apparatus according to claim 49, comprising, in the illumination optical system, a polarization control member which defines a magnitude relation between a component of an electric field in the Y-direction and a component of the electric field in an X-direction perpendicular to the Y-direction, of the illumination light applied onto the first diffraction grating.

63. The exposure apparatus according to claim 49, wherein the second holding mechanism or the substrate holding mechanism comprises a position shift function which shifts a relative positional relation in in-plane directions of the substrate between the second diffraction grating and the substrate, by a predetermined amount in a predetermined direction.

64. The exposure apparatus according to claim 49, wherein a distance between the second diffraction grating and the substrate is set between 1 μm and 500 μm.

65. The exposure apparatus according to claim 49, wherein a distance between the second diffraction grating and the substrate is set between 5 μm and 100 μm.

66. The exposure apparatus according to claim 49, wherein a distance D between the second diffraction grating and the substrate is so set as to satisfy the following relation:

$$30 \times T^2 / \lambda \leq D,$$

where λ is an effective wavelength of the illumination light and T is a minimum period of the second diffraction grating.

67. The exposure apparatus according to claim 49, wherein a distance D between the second diffraction grating and the substrate is so set as to satisfy the following relation:

$$100 \times T^2 / \lambda \leq D,$$

where λ is an effective wavelength of the illumination light and T is a minimum period of the second diffraction grating.

68. The exposure apparatus according to any one of claims 58 to 77, comprising a liquid supply mechanism which fills at least either at least a portion of a space between the second diffraction grating and the substrate, or at least a portion of a space between the first diffraction grating and the second diffraction grating, with a dielectric liquid having a refractive index of not less than 1.2 at a wavelength of the exposure.

69. The exposure apparatus according to claim 68, wherein the dielectric liquid is water.

70. The exposure apparatus according to claim 49, wherein a temporal coherence length of the illumination light is not more than 100 μm.

71. An exposure apparatus for effecting exposure on a photosensitive substrate, of an interference pattern generated by a diffraction grating formed in an optically-transparent flat plate, with illumination light from a light source, said exposure apparatus comprising:

a holding mechanism which holds the diffraction grating formed in the optically-transparent flat plate, at a predetermined position;

a substrate holding mechanism which holds the substrate in alignment at a position opposite to and in proximity to the diffraction grating; and

an illumination optical system which applies the illumination light from the light source onto the diffraction grating, wherein a major portion of the illumination light applied onto an arbitrary point of the diffraction grating comprises a plurality of illumination light beams having respective traveling directions in at least one specific plane including a Y-direction, which is a specific direction in a plane on which the substrate is placed, and including said point, and the traveling directions are not parallel to each other.

72. The exposure apparatus according to claim 71, wherein the optically-transparent flat plate is held so that a direction of a period of the diffraction grating is substantially perpendicular to the Y-direction.

73. The exposure apparatus according to claim 71, comprising a replacing mechanism which replaces the optically-transparent flat plate.

74. The exposure apparatus according to claim 71, wherein the illumination optical system comprises illumination light uniformizing means which substantially uniformizes an intensity distribution of the illumination light in a plane on which the diffraction grating is placed.

75. The exposure apparatus according to claim 74, wherein the illumination light uniformizing means includes at least one fly's eye lens in which lens elements are arrayed along the Y-direction.

76. The exposure apparatus according to claim 87, wherein the illumination light uniformizing means comprises a condensing optical system which substantially limits illumination light incident to an arbitrary lens element in said at least one fly's eye lens, to illumination light distributed in a predetermined range in an X-direction perpendicular to the Y-direction, among illumination light distributed in a predetermined plane on the light source side with respect to the fly's eye lens in the illumination light uniformizing means.

77. The exposure apparatus according to claim 75, wherein the illumination light uniformizing means comprises secondary illuminant position correcting means which arrays a plurality of secondary light sources formed on an exit surface of said at least one fly's eye lens, substantially on a line parallel to the Y-direction.

78. The exposure apparatus according to claim 71, wherein the specific plane is one plane substantially perpendicular to the plane on which the substrate is placed.

79. The exposure apparatus according to claim 71, wherein the specific plane is one plane inclined at a predetermined angle of inclination relative to a direction of a normal to the plane on which the substrate is placed.

80. The exposure apparatus according to claim 71, wherein the specific plane is two planes inclined substantially in symmetry at a predetermined angle of inclination relative to a direction of a normal to the plane on which the substrate is placed.

81. The exposure apparatus according to claim 80, wherein the predetermined angle $\theta$ of the inclination of the specific plane substantially satisfies a relation of $n \times \sin\theta = \lambda / (2 \times T)$ where $\lambda$ is a wavelength of the illumination light, n is a refractive index of a medium on the light source side of the diffraction grating for the illumination light, and T is a period of the diffraction grating.

82. The exposure apparatus according to claim 78, wherein an angular relation of the specific plane to the plane on which the substrate is placed varies according to a position of said point in an X-direction perpendicular to the Y-direction.

83. The exposure apparatus according to claim 71, comprising, in the illumination optical system, a polarization control member which defines a magnitude relation between a component of an electric field in the Y direction and a component of the electric field in an X-direction perpendicular to the Y-direction, of the illumination light applied onto the diffraction grating.

84. The exposure apparatus according to claim 71, wherein the second holding mechanism or the substrate holding mechanism comprises a position shift function which shifts a relative positional relation in in-plane directions of the substrate between the second diffraction grating and the substrate, by a predetermined amount in a predetermined direction.

85. The exposure apparatus according to claim 71, wherein a distance between the diffraction grating and the substrate is set between 1 $\mu$m and 500 $\mu$m.

86. The exposure apparatus according to claim 71, wherein a distance between the diffraction grating and the substrate is set between 5 $\mu$m and 100 $\mu$m.

87. The exposure apparatus according to claim 71, wherein a distance D between the diffraction grating and the substrate is so set as to satisfy the following relation:

$$30 \times T^2 / \lambda \leq D,$$

where $\lambda$ is an effective wavelength of the illumination light and T is a minimum period of the diffraction grating.

88. The exposure apparatus according to claim 71, wherein a distance D between the diffraction grating and the substrate is so set as to satisfy the following relation:

$$100 \times T^2 / \lambda \leq D,$$

where $\lambda$ is an effective wavelength of the illumination light and T is a minimum period of the diffraction grating.

89. The exposure apparatus according to claim 71, comprising a liquid supply mechanism which fills at least a portion of a space between the diffraction grating and the substrate with a dielectric liquid having a refractive index of not less than 1.2 at a wavelength of the exposure.

90. The exposure apparatus according to claim 89, wherein the dielectric liquid is water.

91. The exposure apparatus according to claim 71, wherein a temporal coherence length of the illumination light is not more than 100 $\mu$m.

92. An illumination optical apparatus for applying illumination light from a light source onto a predetermined plane to be illuminated,
wherein a major portion of the illumination light applied onto an arbitrary point of the plane to be illuminated comprises a plurality of illumination light beams having respective traveling directions in at least one specific plane including a Y-direction, which is a specific direction in the plane to be illuminated, and including said point, and the traveling directions are not parallel to each other.

93. The illumination optical apparatus according to claim 92, comprising illumination light uniformizing means which substantially uniformizes an intensity distribution of the illumination light in the plane to be illuminated.

94. The illumination optical apparatus according to claim 93, wherein the illumination light uniformizing means includes at least one fly's eye lens in which lens elements are arrayed along the Y-direction.

95. The illumination optical apparatus according to claim 94, wherein the illumination light uniformizing means comprises a condensing optical system which substantially limits illumination light incident to an arbitrary lens element in said at least one fly's eye lens, to illumination light distributed in a predetermined range in an X-direction perpendicular to the Y-direction, among illumination light distributed in a predetermined plane in the illumination light uniformizing means.

96. The illumination optical apparatus according to claim 94, wherein the illumination light uniformizing means comprises secondary illuminant position correcting means which arrays a plurality of secondary light sources formed on an exit surface of said at least one fly's eye lens, substantially on a line parallel to the Y-direction.

**97.** The illumination optical apparatus according to claim 92, wherein the specific plane is one plane substantially perpendicular to the plane to be illuminated.

**98.** The illumination optical apparatus according to claim 92, wherein the specific plane is one plane inclined at a predetermined angle of inclination relative to a direction of a normal to the plane to be illuminated.

**99.** The illumination optical apparatus according to claim 92, wherein the specific plane is two planes inclined substantially in symmetry at a predetermined angle of inclination relative to a direction of a normal to the plane to be illuminated.

**100.** The illumination optical apparatus according to claim 97, wherein an angular relation of the specific plane to the plane to be illuminated varies according to a position of said point in an X-direction perpendicular to the Y-direction.

**101.** The illumination optical apparatus according to claim 92, comprising a polarization control member which defines a magnitude relation between a component of an electric field in the Y-direction and a component of the electric field in an X-direction perpendicular to the Y-direction, of the illumination light applied onto the plane to be illuminated.

**102.** The illumination optical apparatus according to claim 92, wherein a temporal coherence length of the illumination light is not more than 100 $\mu$m.

# *Fig.1*

# Fig.2

(A)

(B)

# Fig.3

# Fig.4

## Fig.5

# Fig.6

(A)

(B)

(C)

(D)

# Fig.7

(A)

(B)

(C)

# Fig.8

(A)

(B)

## Fig.9

(A)

CL

F1a

F2a

F3a

F4a

20a

F5a

F6a

F7a

F8a

Y

X

Z

(B)

CL

F1b

F2b

F3b

F4b

20b

F5b

F6b

F7b

F8b

Y

X

Z

# Fig.10

(A) (B)

# Fig.11

(A)

IL8c    IL8d    IL8e

LEa

LEb

P1

(B)

$\psi$e    $\psi$e

IL8f    IL8g    IL8h

LEa

LEb

LEa1

LEb1

Z
Y    X

P1

# Fig.12

# Fig.13

# *Fig.14*

# Fig.15

## Fig.16

(A)

J1 J2 J3 ・・・ J8

K1
K2
K3
K4
⋮
K8

12a
IL2   AX1   DG2

Y
Z   X

(B)

AX1   24

L1   R1
L2   R2
L3   R3
L4   R4
L5   R5
L6   R6
L7   R7
L8   R8

23L   23R

Y
Z   X

*Fig.17*

(A)

(B)

# Fig.18

# Fig.19

(A)

(B)

# Fig.20

(A)

(B)

# Fig.21

## INTERNATIONAL SEARCH REPORT

| | International application No. |
|---|---|
| | PCT/JP2006/300404 |

A.  CLASSIFICATION OF SUBJECT MATTER
*H01L21/027*(2006.01), *G03F7/20*(2006.01)

According to International Patent Classification (IPC) or to both national classification and IPC

B.  FIELDS SEARCHED

Minimum documentation searched (classification system followed by classification symbols)
H01L21/027, G03F7/20

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | JP 11-304653 A   (Nikon Corp.),<br>05 November, 1999 (05.11.99),<br>Par. Nos. [0018] to [0020]; Figs. 1, 2<br>(Family: none) | 92-102 |
| X | JP 4-101148 A   (Nikon Corp.),<br>02 April, 1992 (02.04.92),<br>Page 5, lower left column, line 11 to<br>lower right column, line 10; Figs. 1 to 3<br>& EP 496891 A1          & WO 92/03842 A1 | 92-102 |
| A | JP 5-188577 A   (Nikon Corp.),<br>30 July, 1993 (30.07.93),<br>Page 1<br>& US 5703675 A1 | 1-102 |

| ☒ | Further documents are listed in the continuation of Box C. | ☐ | See patent family annex. |
|---|---|---|---|

| | | |
|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 April, 2006 (11.04.06) | 18 April, 2006 (18.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/300404

C (Continuation).   DOCUMENTS CONSIDERED TO BE RELEVANT

| Category* | Citation of document, with indication, where appropriate, of the relevant passages | Relevant to claim No. |
|---|---|---|
| A | JP 5-326365 A  (Nikon Corp.),<br>10 December, 1993 (10.12.93),<br>Page 1<br>& US 5703675 A1 | 1-102 |
| A | JP 7-263312 A  (Nikon Corp.),<br>13 October, 1995 (13.10.95),<br>Page 1<br>& US 5636003 A1 | 1-102 |
| A | JP 6-196389 A  (Nikon Corp.),<br>15 July, 1994 (15.07.94),<br>Page 1<br>& US 5636003 A1          & US 5379091 A | 1-102 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005007125 A